# EUROPÄISCHE PATENTSCHRIFT

(11) **EP 2 480 699 B1**
(45) Veröffentlichungstag und Bekanntmachung des Hinweises auf die Patenterteilung: **06.12.2017**
(21) Anmeldenummer: 10763334.9
(22) Anmeldetag: 24.09.2010
(51) Int. Cl.: C23C 14/00

(54) **VERFAHREN ZUR HERSTELLUNG VON KUBISCHEN ZIRKONOXIDSCHICHTEN**
METHOD FOR PRODUCING CUBIC ZIRCONIA LAYERS
PROCÉDÉ DE FABRICATION DE COUCHES D'OXYDE DE ZIRCONIUM CUBIQUES

(30) Priorität: 25.09.2009 US 245750 P
(43) Veröffentlichungstag der Anmeldung: 01.08.2012
(60) Teilanmeldung: 13154999.0
(73) Patentinhaber: Oerlikon Surface Solutions AG, Pfäffikon, 8808 Pfäffikon SZ (CH)
(72) Erfinder: RAMM, Jürgen, CH-7304 Maienfeld (CH); WIDRIG, Beno, CH-7310 Bad Ragaz (CH)
(74) Vertreter: Troesch Scheidegger Werner AG
(86) Internationale Anmeldenummer: PCT/EP2010/064136
(87) Internationale Veröffentlichungsnummer: WO 2011/036246

(56) Entgegenhaltungen:
- US-A- 5 518 597
- US-A1- 2007 000 772
- US-A1- 2008 020 138
- US-A1- 2008 090 099
- US-B1- 6 245 280
- US-B1- 6 391 164
- CYVIENE J ET AL: "Deposition of nanocomposite Zr-ZrO2 films by reactive cathodic vacuum arc evaporation", MATERIALS SCIENCE AND ENGINEERING B, ELSEVIER SEQUOIA, LAUSANNE, CH, Bd. 118, Nr. 1-3, 25. April 2005 (2005-04-25), Seiten 238-241, XP025304712, ISSN: 0921-5107, DOI: DOI:10.1016/J.MSEB.2004.12.036 [gefunden am 2005-04-25]
- WEIFENG LI ET AL: "Structure and properties of zirconia (ZrO2) films fabricated by plasma-assisted cathodic arc deposition; Structure and properties of zirconia (ZrO2) films", JOURNAL OF PHYSICS D. APPLIED PHYSICS, IOP PUBLISHING, BRISTOL, GB, Bd. 40, Nr. 8, 21. April 2007 (2007-04-21) , Seiten 2293-2299, XP020112358, ISSN: 0022-3727, DOI: DOI:10.1088/0022-3727/40/8/S08
- LAURIKAITIS ET AL: "Deposition of zirconium oxynitride films by reactive cathodic arc evaporation and investigation of physical properties", THIN SOLID FILMS, ELSEVIER-SEQUOIA S.A. LAUSANNE, CH, Bd. 516, Nr. 7, 29. Januar 2008 (2008-01-29), Seiten 1549-1552, XP022436978, ISSN: 0040-6090, DOI: DOI:10.1016/J.TSF.2007.03.063

## Beschreibung

Die Erfindung bezieht sich auf Verfahren zur Herstellung von Zirkonoxidschichten, sowie auf Schichten und/oder auf Schichtsysteme, die Zirkonoxid beinhalten. Die Erfindung bezieht sich auch auf Produkte mit Zirkonoxidschichten und deren Anwendungen.

Die Zirkonoxid-basierenden Schichten sind vor allem in ihrer kubischen und/oder tertragonalen Ausbildung beispielsweise im Bereich der Anwendung in Festelektrolyt Brennstoffzellen interessant.

Die Ionenleitfähigkeit der Zirkonoxid-basierenden Schichten und deren thermische Beständigkeit erlauben aber auch den Einsatz im Bereich der Sensorik.

Auch hier wird bevorzugt auf die kubische Kristallstruktur gesetzt, wie beispielsweise in US_20040084309 beschreiben: Das Dokument beschreibt einen Sensor, der auf einer Zr-O Schicht basiert, die tetragonal oder kubisch ist und weniger als 5 mol% Beimengungen der monoklinen Phase enthält. Begründet wird die Notwendigkeit der Begrenzung der monoklinen Phase damit, dass so die Rissbildung bei Wechseltemperaturbelastung vermieden werden kann, die durch die Volumenänderungen beim Phasenübergang entsteht. Vermieden wird die monokline Phase mittels Stabilisatoren. In Abschnitt 101 wird auch beschrieben, dass eine kleine mittlere Korngrösse (kleiner 2.5 um) in der Schicht von Vorteil ist, da sie sich stabiler gegenüber Phasentransformationen verhält. In Abschnitt 103 sind bevorzugte Verhältnisse der kubischen zur tetragonale Phase angegeben (400) für kubische Phase und (004) und (220) für tetragonale Phase.

Aufgrund der guten mechanischen Eigenschaften in Verbindung mit den guten thermischen Barriereverhalten könnten die Schichten aber auch auf dem Gebiet der Werkzeugbeschichtung, besonders der Beschichtung von Bauteilen mit Vorteil eingesetzt werden. Dabei steht das Design von tribologischen Systemen im Vordergrund. Die einstellbare Morphologie in Verbindung mit der einstellbaren Härte der Schichten und die einfache Kombination mit anderen Oxidschichten können zu einer Optimierung des Verschleisses von beschichtetem Werkstück/Bauteil und dem Verschleiss des Gegenkörpers benutzt werden.

Eine weitere Anwendung wird in US_20070004589 beschrieben: Dort wird eine Mischung aus tetragonalen und kubischen Zr-O unter Zusatz von Stabilisatoren für die Anwendung in Katalysatoren eingesetzt.

Zirkonoxid-basierte Schichten lassen sich bezüglich ihrer Zusammensetzung vor allem als Zr-O, Zr-O-N, Zr-St-O, Zr- St O-N beschreiben, wobei St für Stabilisatorenelemente steht, die zur Stabilisierung der kubischen bzw. tetragonalen Struktur des Zr02 beitragen. Bevorzugt wird Y als ein Stabilisator eingesetzt. Im Stand der Technik sind unterschiedliche Verfahren zur Herstellung von Zirkonoxid-basierten Schichten bekannt, die im Folgenden kurz angesprochen werden sollen.

### a) Schichten mit Sintern hergestellt:

In US_05709786 bzw. EP_00669901 wird ein Sinterprozess zur Herstellung von Festelektrolyten aus Zr-0 beschrieben.

Dabei wird die Beifügung von Stabilisatoren zur Erhöhung der Ionenleitfähigkeit des Zr-O diskutiert, sowie auch das Co-sintern mit metallischen und keramischen Pulvern zur Herstellung von Kontakten in Verbindung mit dem Festelektrolyten. Gemäss diesem Stand der Technik wird als wesentlich beschrieben, dass Pulver mit Korngrössen im Nanometerbereich die Temperaturabhängigkeit der Ionenleitfähigkeit reduzieren und dass die kleine Grösse der Pulver beim Sinterprozess vorteilhaft ist und die notwendige Temperatur zum Sintern herabsetzt. Das wird vor allem in dem Zusammenhang diskutiert, dass einige für die Erhöhung der Ionenleitfähigkeit vorteilhafte Stabilisatoren bei den üblichen Pulvergrössen nur bei sehr hohen Temperaturen gesintert werden können. Die Schrift beschreibt die Schwierigkeiten der Schichtherstellung beim Sinterprozess und zeigt einen Lösungsansatz durch die Herabsetzung der Pulvergrösse. Die Schichten werden analytisch nicht charakterisiert, aber es wird die Notwendigkeit demonstriert, dass es für bestimmte Anwendungen vorteilhaft ist, die Schichthärte und weitere mechanische Eigenschaften der Zr-O Schicht im tribologischen System anpassbar zu machen.

Die Zr-O Schichten der US 20040084309, die zum Einsatz in einem Sensor geeignet sind, werden ebenfalls in einem Sinterprozess hergestellt.

Beim Sinterverfahren führen allerdings die notwendigen hohen Temperaturen zu erheblichen Nachteilen. Um diese herabzusetzen, werden kostspielige Pulver im Nanometerbereich als Ausgangsmaterialien benutzt. Bei hochschmelzenden Materialien müssen die üblichen Sintertemperaturen (um 1500°C) noch weiter erhöht werden, um den Sinterprozess zu ermöglichen. Das ist vor allem dann der Fall, wenn die hochschmelzenden stabilisierenden Elemente beigefügt werden müssen, wie es in US_05709786 beschrieben wird. Aus dieser Schrift wird auch klar, dass es wichtig ist, die Festelektrolytschicht mit weiteren Funktionsschichten (z.B. Elektroden) zu kombinieren bzw. mit mechanischen und thermischen Schutzschichten. Das heisst, dass es für die Anwendung notwendig ist, ein ganzes Schichtpaket mit aufeinander abgestimmten Funktionen herzustellen, wobei die Herstellungstemperaturen aufeinander abgestimmt sein müssen um zu einem guten Schichtpaket zu gelangen (z.B. Interfaceproblematik, Schichtstabilität). Aus der Schrift wird auch deutlich, dass hohe Herstelltemperaturen aus Materialsicht vorteilhaft sind für den Einbau von Stabilisatoren, diese aber nicht einfach realisiert werden können und für einen Schichtverbund noch schwieriger zu realisieren sind.

Es kommt hinzu, dass die durch das Sinterverfahren hergestellten Schichten eher als kompakte Materialien anzusehen sind. Sie müssen oft noch stabilisiert (z.B. durch Netze) werden, damit der mechanische Verbund gewährleistet ist. Es hängt von der Sintertemperatur ab, welche Struktur des Zr-O erreicht wird und es sind Stabilisatoren notwendig, um die kubische oder tetragonale Struktur zu erzielen. Die Phasen, die bei diesem Verfahren entstehen entsprechen im Wesentlichen dem, was man aus dem Phasendiagramm ablesen kann, weil die Prozesse ja im Wesentlichen beim thermischen Gleichgewicht vor sich gehen. Es gibt Stabilisatoren, die nur bei sehr hohen Temperaturen gesintert werden können und damit technisch schwierig oder nicht realisierbar sind. Dadurch wird die mögliche Schichtvielfalt eingeschränkt.

Das "Ankoppeln" der gesinterten Schicht an andere Materialien ist schwierig, da unterschiedliche Temperaturen notwendig sind, um einen Verbund herzustellen und das zu verbindende Material den Temperaturbereich einschränkt. Die Schichten sind brüchig wie etwa Porzellan und es ist fast unmöglich, Multilagenstrukturen herzustellen. Die Korngrössen der hergestellten Materialien sind durch die der Ausgangspulver und das Sinterverfahren bestimmt. Das einfache Aufbringen von thermischen Schutzschichten oder Metallelektroden kann kaum in einen Prozess erfolgen.

Die Ausgangsmaterialien sind beim Sintern (Korngrösse) von ausschlaggebender Bedeutung um qualitativ hochwertige kubische bzw. tetragonale ZrO2 Schichten herzustellen. In beiden Fällen muss grosser Aufwand betrieben werden, um die Reproduzierbarkeit im Ausgangsmaterial zu gewährleisten. Eine verbesserte Herstellmethode sollte daher sowohl den Herstellprozess des Ausgangsmaterials (Target) als auch die zeitliche Konstanz der Materialqualität während des Beschichtungsprozesses gewährleisten.

### b) Schichten mit Plasmaspritzen hergestellt:

In US 20040022949 wird eine Verschleissschutzschicht für Gasturbinen aus kubischen oder tetragonalen Zr-0 offenbart, die durch Plasmaspritzen hergestellt wird. Eine Behandlung im Wasserdampf transformiert diese Schicht in die weichere monokline Struktur, die sich beim Betrieb in einer Gasturbine wieder in eine kubische oder tetragonale Struktur umwandelt. Sinn dieser zusätzlichen Schichtbehandlung ist es, das Einlaufverhalten des Bauteils so zu gestalten, dass der Gegenkörper nicht verschlissen wird und die weiche Schicht angepasst wird. Wieder werden die üblichen Stabilisatoren verwendet, wobei Yttriumoxid (Y-O) im Bereich zwischen 0,3 und 20 mol% angegeben wird.

In US 20050170200 wird eine thermische Barriereschutzschicht beschrieben, die aus einer Haftschicht, einer teilweise stabilisierten Zr-O Schicht und einer weiteren vollständig stabilisierten Zr-O Schicht besteht. Damit werden die guten mechanischen Eigenschaften des teilweise stabilisierten Zr-0 mit den guten thermischen Schutzeigenschaften des vollständig stabilisierten Zr-0 kombiniert. Die Schichten werden mittels Plasmaspritzens hergestellt.

Die im Zusammenhang mit den Sinterverfahren erwähnte Interfaceproblematik besteht auch bei den thermischen Spritzverfahren. Auch hier ist es schwierig, eine gute Haftung zwischen der abgeschiedenen Schicht und dem zu beschichteten Substrat zu erzielen. Zudem ist es schwierig in diesem Verfahren graduelle Übergänge zwischen verschiedenen Materialien zu realisieren.

Wie beim Sintern sind auch bei der Elektronenstrahlverdampfung (Tiegelmaterial mit Vorbehandlung) die Ausgangsmaterialien von ausschlaggebender Bedeutung um qualitativ hochwertige kubische bzw. tetragonale Zr02 Schichten herzustellen. In beiden Fällen muss grosser Aufwand betrieben werden, um die Reproduzierbarkeit im Ausgangsmaterial zu gewährleisten. Eine verbesserte Herstellmethode sollte daher sowohl den Herstellprozess des Ausgangsmaterials (Target) als auch die zeitliche Konstanz der Materialqualität während des Beschichtungsprozesses gewährleisten.

### c) Schichten mittels Elektronenstrahlverdampfen hergestellt:

US_20060171813_beschreibt eine Anwendung von Zr-O Schichten auf Turbinenschaufeln. Auf einer inneren dichten Schicht die kubisches Zr-O oder Hf-O enthält wird eine weitere thermische Schutzschicht aufgebracht, die aus einer Multilagenschicht besteht, welche aus Zr-0 und einem Metalloxid, beispielsweise Ta-O oder Nb-O besteht. Die Schichten werden mittels Elektronenstrahlverdampfung abgeschieden.

In US 20080090100 A1 wird eine thermische Barriereschicht beschrieben, die mittels Elektronenstrahlverdampfung hergestellt wird.

In US 05418003 wird ein PVD Verfahren (Elektronenstrahlverdampfung) beschrieben, das zur Herstellung von thermischen Barriereschichten auf Zr-0 Basis dient. Um das Spritzen beim Verdampfen zu reduzieren, wird in US 06042878 A eine spezielle Vorbehandlung des Tiegelmaterials (ingot) angegeben.

In US 6586115 werden, ohne näher auf die Prozesse einzugehen, verschiedene PVD und CVD Methoden genannt um thermische Barriereschichten (TBC) aufzubringen. Dabei wird auch das Elektronenstahlverdampfen von Yttrium stabilisiertem Oxid erwähnt.

Die Elektronenstrahlverdampfung ermöglicht prinzipiell eine gute Haftung, da diese unter Vakuum abläuft und die Substratoberflächen durch Plasmabehandlung gereinigt und aktiviert werden können. Allerdings ist der Ionisierungsgrad des verdampften Materials bei der Elektronenstrahlverdampfung klein, was meist nur ein kolumnares Wachstum der Schichten zulässt, das bei thermischen Schutzschichten erwünscht, aber für andere Anwendungen und unter dem Aspekt der Haftung nachteilig ist. Vorteilhaft wäre der höhere Ionisierungsgrad des Dampfes auch unter dem Aspekt, dass er es zuliesse über einen Substratbias höhere Energie in die Schichtsynthese einzubringen und somit bessere Voraussetzungen dafür zu schaffen, dass man die tetragonalen oder kubischen Strukturen im ZrO2 erreichen könnte, sogar ohne den Einbau von Stabilisatoren. Das ist aber weder hier noch in anderen PVD Verfahren bisher gelungen. Ein weiterer gewichtiger Nachteil bei diesem Verfahren ist der Aufwand, den man betreiben muss, um eine möglichst spritzerfreie Verdampfung zu erreichen. Um nämlich die abgeschiedenen Schichten durchgehend oxidieren zu können werden dem Tiegelmaterial Oxide beigegeben bzw. es werden nur Oxide benutzt. Da diese isolierend sind, ist das Einschmelzen bzw. Sublimieren der Oxide mit dem Elektronenstrahl nicht problemlos hinsichtlich Spritzern, aber auch einer Entmischung des Tiegelmaterials. Beides schlägt sich in einer komplizierten Prozessführung nieder. Zudem muss dem Prozess noch zusätzlicher Sauerstoff als Reaktivgas beigegeben werden, um die Schicht mit genügend Sauerstoff zu versehen.

Eine weitere Problematik ist darin zu sehen, dass beim Elektronenstrahlverdampfen das Material schockartig aufgeschmolzen wird. Hierdurch entsteht im Tiegel ein grosser Temperaturgradient, der nicht selten zu einem Tiegelbruch führt und diesen unbrauchbar macht. Diese Problematik wird im Zusammenhang mit Zirkonium in US 06143437 adressiert. Der dort verwendete Tiegel umfasst bereits Zirkonoxid Pulver in kubischer Phase.

Ebenso beschreibt US 20070237971 die Verwendung eines Targets mit spezieller Zusammensetzung eines keramischen Pulvers. für die Elektronenstrahlverdampfung offenbart. Die aufwändige Methode zur Herstellung dieses Targets wird in US 20080088067 beschrieben. Die damit verbundenen Kosten stehen allerdings einer wirtschaftlichen Nutzung des Prozesses erheblich entgegen.

Es sei nochmals betont, dass die Schichten, die mit den Elektronenstrahlverfahren hergestellt werden, meist nur kolumnare Schichtmorphologie zulassen, da der Ionisierungsgrad des Metalldampfes zu gering ist, um die Beweglichkeit an der Substratoberfläche heraufzusetzen. Das schränkt natürlich auch die Einflussnahme auf die Schichtstruktur ein. Die Pflege der Schmelze ist ein anderer Schwachpunkt des Verfahrens. Sie muss sehr sorgfältig und aufwendig betrieben werden, damit es zu keinen Entmischungen kommt, die sich dann in der Schichtzusammensetzung wiederfinden. Ein Verdampfen von Legierungen ist kaum möglich, d.h. man muss die prozesstechnisch weitaus schwierigere Oxidverdampfung mit Sauerstoffzugabe nutzen, um halbwegs stöchimetrische Schichten zu erreichen.

### d) Schichten mittels Ion Beam Assisted Deposition (IBAD):

In US 20020031686 wird u.a. ein IBAD Verfahren offengelegt, das die Herstellung stark (biaxial) orientierten YSZ (Yttrium stabilisiertes Zirkonoxid) auf einer SiO2 Schicht erlaubt. Die Figuren zeigen für das YSZ die (200) und (400) Reflexe im XRD-Spektrum. Das YSZ dient in dieser Anwendung als Wachstumsunterlage für die nächstfolgende Schicht, in dieser Anwendung Ce-O, Ru-O und/oder LSCO (Lanthan Strontium Cobald Oxid). Ziel ist es, leitfähige Oxide aus diesen Materialien herzustellen, wozu es die YSZ Unterlage braucht. Es werden in dieser Schrift Beispiele zur Herstellung von YSZ Schichten angegeben, die bei 700°C Substrattemperatur abgeschieden wurden. Ohne weiteren Nachweis wird zusätzlich behauptet, dass der Prozess auf niedrigere Temperaturen zwischen 450°C und 600°C ausgedehnt werden kann. Die tiefe Prozesstemperatur ist eine wünschenswerte Eigenschaft oder Bedingung, falls die Schichten auf bereits vorfabrizierten Substraten, beispielsweise Si-Wafern im Bereich der Halbleiterindustrie, abgeschieden werden sollen. Die Schrift US_20020031686 offenbart im XRD-Spektrum die (200) und die (400) Reflexe vom YSZ im 2Θ Bereich zwischen 20° und 80°. Das IBAD-Verfahren wird in US_05872080 beschrieben.

Das IBAD Verfahren beruht auf den Beschuss von Oberflächen, einmal zum Abtragen von Material, zum anderen, um eine bestimmte Wachstumsrichtung des im Vakuum abgeschiedenen Materials zu erzwingen. Problematisch dabei ist, dass die Aufwachsraten bei dieser Technik klein sind und sich nicht für Anwendungen eignen, bei denen viel Material grossflächig und kostengünstig abgeschieden werden muss.

Bemerkenswert scheint, dass die Reflexe in US_20020031686, für die man die höchste Intensität beim tetragonalen bzw. kubischen ZrO2 erwartet (bei 28=30° und 50°) fast nicht nachweisbar sind. Das ist ein Indiz dafür, dass man bei den IBAD Verfahren durch das Ionenbombardement stark texturierte Schichten herstellt und es ist fraglich, wie gross die Anteile des kubischen YSZ wirklich sind. Es ist aber auch ein Indiz dafür, dass bei diesem Prozess schon Substrattemperaturen von immerhin 700°C nicht ausreichen, eine deutliche kubische Phase im YSZ zu erzielen. Das ist eine wesentliche Limitation bei den bisherigen PVD Verfahren: die Substrattemperaturen im Bereich zwischen 200°C und 600°C reichen nicht aus, um die kubische Phase im ZrO2 zu erreichen.

### e) Schichten in kombinierten PVD Verfahren (Sputtern-Funkenverdampfung)

In J. Cyviene et al., Surface and Coatings Technology, 180-181 (2004) 53-58 wird eine Kombination von Sputtern und Funkenverdampfung beschrieben. Dabei wird ein Zr Target für den Funkenverdampfer benutzt und ein Y Target für die Sputterquelle. Der Prozess läuft unter einem Prozessdruck von 0.2 Pa ab, wobei dem Argon Sauerstoff bis zu einem maximalen Partialdruck von 0.08 Pa beigegeben wird.

Allerdings beleuchtet das in Cyviene_Surf.Coat.Tech_180-181_2004 beschriebene kombinierte Verfahren Sputtern-Funkenverdampfung beleuchtet einige Probleme, die sowohl die Herstellmethode wie auch die abgeschiedene Schicht betreffen. Die Schrift geht auf die Problematik der Vergiftung des Sputtertargets ein, d.h. beschreibt, dass beim Betrieb des Sputtertargets an der Kante zum metallischen Mode gearbeitet werden muss, was eine aufwendige Prozesskontrolle bedingt. Sowohl der Sputterbetrieb wie der Funkenbetrieb findet im Argon Arbeitsgas statt und es wird lediglich Sauerstoff in kleinen Mengen beigegeben. Der Betrieb in reinem Sauerstoff wird nicht beschrieben, würde aber ohne weitere Massnahmen zu vollständigen Instabilitäten unter den beschriebenen Bedingungen führen: fast keine Rate mehr beim Sputtern, instabile Funkenverdampfung wegen Aufoxidation des Funkentargets und der Funkenanode und schliesslich Unterbruch der DC Funkenentladung.

In Cyviene werden die Probleme auf der Schichtseite beim kombinierten Sputter-Funkenverfahren beschrieben, die durch die vorliegende Erfindung vermieden werden. Es wird beschrieben, dass die Funkenentladung mit dem Zr Target in Argon mit Sauerstoffzugabe bei der synthetisierten Schicht nicht zu der kubische bzw. tetragonalen Phase führt, sondern lediglich eine monokline Struktur erreicht wird. Erst durch die Zugabe von Y als Stabilisator über den Sputterprozess kann das YSZ in der kubischen bzw. tetragonalen Phase nachgewiesen werden. Das geht übrigens auch einher mit den Erfahrungen die Erfinder der vorliegenden Erfindung, denen, wie es in *US_20080090099_A1* offenbart ist (Tabelle 3, VNr 29), gelungen ist, ebenfalls ZrO2 in einem stabilen Funkenprozess unter ausschliesslicher Sauerstoffatmosphäre und bei wesentlich höheren Drucken herzustellen, der aber auch keine kubische bzw. tetragonale Struktur des ZrO2 nachweisen konnte, ganz im Gegensatz zu den "hochtemperatur" Korundstrukturen in dem dort beschriebenen A1-Cr-O Materialsystem.

Aus den XRD Spektrum Cyviene_Surf.Coat.Tech_180-181_2004 wird noch ein anderer Sachverhalt deutlich. Man sieht die Bragg peaks der hexagonalen Phase des Y-O und des hexagonalen Zr. Das sind Schichtkomponenten, die wesentlich zu Schichtinstabilitäten beitragen können, falls es zu thermischen Wechselbelastungen kommt, wie das gewöhnlich bei den Anwendungen als Festelektrolyt oder thermische Barriereschicht der Fall ist.

Diese Probleme decken sich auch teilweise mit denen beim IBAD: Vergiftungserscheinungen des Targets, Schichtzusammensetzungen, die noch andere Materialkomponenten enthalten, und eine schwierige Kontrolle der Kristallstruktur der synthetisierten Schicht bei den tiefen Substrattemperaturen zwischen 200°C und 600°C zur Folge hat.

Ausserdem, wie bereits oben bemerkt sind die Reflexe in US 20020031686, für die man die höchste Intensität beim tetragonalen bzw. kubischen ZrO2 erwartet (bei 28=30° und 50°) fast nicht nachweisbar. Damit liegt aber sehr wahrscheinlich lediglich ein sehr kleiner Anteil an kubischem YSZ vor.

Ferner sind Verfahren zur Herstellung einer Zirkonoxid-basierten Schicht unter Einsatz reaktiven Funkenverdampfens bereits bekannt, beispielsweise aus:
CYVIENE J ET AL: "Deposition of nanocomposite Zr-Zr02 films by reactive cathodic vacuum arc evaporation", MATERIALS SCIENCE AND ENGINEERING B, ELSEVIER SEQUOIA, LAUSANNE, CH, Vol. 118, No. 1-3, 25 April 2005 (2005-04-25), pages 238-241, XP025304712, ISSN: 0921-5107, DOI: D01:10.1016/J.MSEB.2004.12.036;
WEIFENG LI ET AL: "Structure and properties of zirconia (Zr02) films fabricated by plasma-assisted cathodic arc deposition; Structure and properties of zirconia (Zr02) films", JOURNAL OF PHYSICS D. APPLIED PHYSICS, IOP PUBLISHING, BRISTOL, GB, Vol. 40, No. 8, 21 April 2007 (2007-04-21), pages 2293-2299, P0201 12358, ISSN: 0022-3727, DOI: D01:10.1088/0022-3727/40/8/S08; oder US 2008/090099 A1.

### f) Andere Verfahren:

US_20060009344_beschreibt die Herstellung eines Zr-O Substrates, das sowohl Komponenten monokliner wie kubischer Struktur des Zr-O umfasst und das deshalb besonders geeignet ist, eine bessere Haftung zur eigentlichen kubischen Zr-0 Schicht herzustellen. Das Verfahren ist ein Aerosol "CVD"-Verfahren. Wieder wird Wert darauf gelegt, dass die Körner Grössen zwischen 5 nm und 1000 nm haben und wieder wird das Zr-0 mit Y-O zwischen 4 mol% und 8 mol% stabilisiert.

All die beschriebenen Verfahren lassen den Schluss zu, dass es ein grosses Bedürfnis nach gegenüber dem Stand der Technik verbesserten Zirkonoxidschichten gibt, ebenso wie es ein Bedürfnis nach einem wirtschaftlichen und technisch beherrschbaren Verfahren zur Herstellung solcher Schichten gibt.

Der vorliegende Erfindung liegt daher die Aufgabe zugrunde Verfahren zur Herstellung von Zirkonoxid-Schichten anzugeben, welche nicht oder in wesentlich geringerem Umfang mit den oben geschilderten Problemen des Stands der Technik behaftet ist.

Mit der vorliegenden Erfindung soll auch eine Verfahren zur Herstellung von Zirkonoxidschichten angegeben werden, welches es ermöglicht in weitem Umfang und im Wesentlichen ohne starke Änderung der Schichtzusammensetzung die Morphologie und insbesondere die Grösse der Kristallite zu steuern.

Der vorliegenden Erfindung liegt auch die Aufgabe zugrunde Zirkonoxid-Schichten zu offenbaren, die im Wesentlichen in kubischer und/oder tetragonaler Struktur vorliegen und die im Vergleich zum Stand der Technik in wesentlich geringerem Umfang Bestandteile umfassen, die nicht kubisches Zirkonoxid oder nicht tetragonales Zirkonoxid sind. Dies bezieht sich auf Schichten, die einen oder mehrere klassische Stabilisatoren aufweisen.

Als klassische Stabilisatoren werden im Rahmen dieser Beschreibung Stabilisatoren bezeichnet, welche in Reinform bei Raumtemperatur und unter Normaldruck als Festkörper vorliegen. Beispiele für solche klassischen Stabilisatoren sind Yttrium, Magnesium, Kalzium, Scandium und/oder der Metalle der seltenen Erden der Gruppe IIIA des Periodensystems. Hier seien noch zusätzlich erwähnt Sr, Ba, Ni, Fe, Co, La, Nd, Gd, Dy, Ce, Al, Bi, Ti, Tb, Eu, Sm. Diese genannten Stabilisatoren finden sich dann als Oxide oder Mischoxide in der synthetisierten Schicht wieder. Unter den Begriff der klassischen Stabilisatoren sollen auch die Mischungen der oben beispielhaft erwähnten Materialien gelten.

Die Aufgabe wird durch ein Verfahren nach Anspruch 1 gelöst. Gattungsgemässe Verfahren zur Herstellung von Schichten wurden bereits in den Anmeldungen US 20070000772 A1 und US 20080020138 A1 beschrieben und werden hier als bekannt vorausgesetzt. Insbesondere die US 20080090099 A1 beschreibt auch die entsprechende Herstellung von ZrO2 Schichten. Der Prozess ist so stabil ausgelegt, dass die Funkentargets in Reaktivgasdrucken zwischen 0.1 Pa und 10 Pa betrieben werden können.

Im Unterschied zu den dort beschriebenen Verfahren werden nun jedoch erfindungsgemäss zusätzliche Massnahmen ergriffen, um Zirkonoxid in der kubischen und/oder der tetragonalen Kristallstruktur auf Substraten abzuscheiden.

In einer ersten Ausführungsform der vorliegenden Erfindung wird die Aufgabe gelöst durch ein Verfahren zur Herstellung einer Zirkonoxid-basierten Schicht auf einem AblegeSubstrat, unter Einsatz reaktiven Funkenverdampfens, mit gepulstem Funkenstrom und/oder mit Anlegen eines zum Funkentarget senkrechten Magnetfeldes, wobei ein ein elementares Zirkon und mindestens einen Stabilisator umfassendes Mischtarget eingesetzt wird.

In einer Variante dieser Ausführungsform wird dabei die Schicht in kubischer und/oder tetragonaler Kristallstruktur hergestellt.

Gemäss der ersten Ausführungsform der vorliegenden Erfindung besteht mithin eine erfinderische Massnahme darin, für das Funkenverdampfen ein Mischtarget zu verwenden, welches elementares Zirkon und einen/oder mehrere klassische Stabilisatoren im in der Schicht gewünschten Konzentrationsverhältnis umfasst. Wie sich erstaunlicherweise herausgestellt hat, lässt sich ein solches Zirkon-Stabilisator Mischtarget mittels gepulster Funkenquelle und/oder mittels geringem senkrechten Magnetfeld problemlos unter Sauerstoffdrücken betreiben, die auch deutlich über 0.1 Pa liegen und sogar bis zu 10 Pa und darüber hinaus gehen können.

In einer Variante dieser Ausführungsform wird mithin der Sauerstoffpartialdruck über 0.1Pa gewählt, vorzugsweise mindestens zu 10Pa.

Die Konzentrationsverhältnisse des Mischtargets reproduzieren sich im Wesentlichen in den Konzentrationsverhältnissen der auf den Substraten aufgebrachten Schichten, und zwar im Wesentlichen unabhängig vom Sauerstoffdruck.

In einer Variante dieser Ausführungsform wird somit das Konzentrationsverhältnis von Zirkonoxid und Stabilisator an der Schicht mindestens im Wesentlichen durch das Konzentrationsverhältnis von elementarem Zirkonium und Stabilisator am Mischtarget vorgegeben.

Bei genügend hoher Stabilisatorkonzentration ist automatisch für das Vorliegen der kubischen und/oder tetragonalen Kristallstruktur gesorgt. Beim Sauerstoffdruck kann es sich um einen Partialdruck oder einen Totaldruck handeln.

In einer Variante dieser Ausführungsform wird mithin, durch Wahl der Konzentration des Stabilisators im Mischtarget, die kubische und/oder tetragonale Kristallstruktur erreicht.

Damit kann im Verfahren der Sauerstoffdruck als hinsichtlich Schichtzusammensetzung freier Parameter betrachtet und eingestellt werden. Hingegen haben verschiedene Experimente gezeigt, dass der Sauerstoffdruck oder -fluss erstaunlicherweise als massgeblicher Einflussfaktor auf die Schichtmorphologie angesehen werden kann. Somit wurde von den Erfindern ein Verfahren erfunden, welches über die Wahl der Konzentrationsverhältnisse des Mischtargets eine Wahl der Schichtzusammensetzung ermöglicht und im Wesentlichen unabhängig davon, über die Wahl des Sauerstoffpartialdrucks, die Wahl der Schichtmorphologie, wie zum Beispiel die Grösse der Kristallite oder die Frage des kolumnaren Wachstums zulässt. Dabei ist zusätzlich bemerkenswert, dass dies bei relativ moderaten Substrattemperaturen geschehen kann.

In einer Variante dieser Ausführungsform wird der Sauerstoffpartialdruck, als bezüglich des Erreichens kubischer und/oder tetragonaler Kristallstruktur mindestens im Wesentlichen freier Stellparameter, für die Vorgabe der Schichtmorphologie eingesetzt.

In einer weiteren Variante dieser Ausführungsform, auf die weiter unten vermehrt eingegangen werden soll, umfasst das Reaktivgas, nebst Sauerstoff, Stickstoff.

Wie oben angetönt wird gemäss einer weiteren Ausführungsform der vorliegenden Erfindung die Verwendung des Stickstoffs als zusätzliches Reaktivgas und die erste erfindungsgemässe Ausführungsform, d.h. die Verwendung eines einen klassischen Stabilisator enthaltenden Zirkoniummischtargets in Kombination ausgeführt. Dies ermöglicht die Herstellung von kubischen und/oder tetragonalen Zirkonoxidschichten mit weniger Stabilisatorkonzentration als sonst üblich. Durch das Vorhandensein von unter Umständen geringer Konzentration von klassischem Stabilisator kann in grossem Umfang der Sauerstoffgasfluss und damit mit die Morphologie der aufgebrachten Schicht gezielt eingestellt werden.

Die Erfindung soll nun im Detail und anhand der folgenden Abbildungen Tabellen und Figuren beispielhaft beschrieben werden.

Es wird nun zunächst eine der möglichen Anwendungen genauer diskutiert um daran fest zu machen, welche Anforderungen ein entsprechendes Verfahren und/oder eine entsprechende Schicht vorzugsweise erfüllen sollte. Die Aufzählung der Anforderungen ist dabei im Wesentlichen nicht kumulativ zu verstehen, wobei es natürlich von Vorteil sein kann, wenn gleich mehrere dieser Eigenschaften oder gar alle erfüllt sind.

Anschliessend wird kurz auf eine Besonderheit der für die Verfahrensbeispiele verwendeten Beschichtungsanlage eingegangen, die vorzugsweise zu realisieren ist und zu besonders stabilen Beschichtungsprozessen führt.

Anschliessend werden beispielhaft verschiedene Beschichtungsprozesse aufgelistet.

Erst danach werden die damit hergestellten Schichten charakterisiert.

Nach der Charakterisierung schliesst sich eine Diskussion und Interpretation der gefundenen Charakteristika an.

Ein Thema im Zusammenhang mit der eventuell auch erfinderischen Verwendung der vorliegenden Erfindung betrifft die Herstellung eines Materials in Schichtform, das hohe Sauerstoffionenleitfähigkeit aufweist und besonders für Festelektrolytbrennstoffzellen geeignet ist.

Eine typische Festelektrolytbrennstoffzelle ist beispielsweise in S.C.Singhal, Recent Progress in Zirkonia-Based Fuel Cells for Power Generation, Fifth International Conference on Science and Technology of Zirkonia, August 16.-22.1992, Melbourne, Australia beschrieben. Daraus geht hervor, dass die eigentliche Festelektrolyschicht beidseitig noch mit porösen Elektroden (Kathode luftseitig, Anode Fuelseitig) versehen werden muss und dass es dann noch zusätzliche "dichte" Interconnects benötigt, um eine komplette Brennstoffzelle zu fertigen. Das Design der Brennstoffzelle basiert also auf einem kompletten Schichtsystem, dass intensiver thermischer Wechselbelastung ausgesetzt ist. Der Einsatz der Zelle unter diesen Bedingungen stellt enorme Anforderungen an die Stabilität des gesamten Schichtpaketes hinsichtlich der Vermeidung von Diffusion und Stabilität der Schichtstruktur. Besonders wichtig sind die chemische Stabilität des Festelektrolyten und dessen kristalline Struktur. Diese Temperaturstabilität schliesst im Besonderen ein, dass es zu keinen oder wenigen temperaturbedingten Phasenumwandlungen im Festelektrolyt kommt. Wichtig ist auch die Kontrolle bzw. Vermeidung von Diffusionsvorgängen innerhalb der Zelle, um "Alterungserscheinungen" oder Performanceverlusten zu begegnen. Von grosser Bedeutung für die Stabilität der Zelle ist die Anpassung der thermischen Ausdehnungskoeffizienten unter den verschiedenen Schichtmaterialien, die die Zelle ausmachen.

Aus diesen allgemeinen Überlegungen gelangten die Erfinder zu folgenden konkreten Anforderungen an die Festelektrolytschicht und das Gesamtschichtpaket der Brennstoffzelle und es ergibt sich mithin eine erfindungsgemässe Verwendung der bis anhin diskutierten Verfahren für die Herstellung einer Festelektolytschicht in einer Brennstoffzelle.

Wird eine Zirkonoxid Schicht als Festelektrolytschicht eingesetzt so sollte sie vorzugsweise vorwiegend aus kubischem und/oder tetragonalem ZrO2 bestehen, um die Phasenumwandlung in eine monokline Struktur zu vermeiden.

Bei der Verwendung von klassischen Stabilisatoren sollte vorzugsweise deren Einbau problemlos sein und die freie Auswahl der klassischen Stabilisatoren sollte nicht durch die Herstellmethode eingeschränkt werden.

Somit gilt für eine Variante der erfindungsgemässen Verwendung der genannten Verfahren: Der Stabilsator wird frei gewählt.

Es sollten sowohl Schichtzusammensetzung als auch Phasenzusammensetzung als auch Schichtmorphologie vorzugsweise weitgehend unabhängig voneinander mittels einfach zu regelnder Parameter der Herstellungsmethode veränderbar sein.

Somit gilt für eine Variante der erfindungsgemässen Verwendung der genannten Verfahren: Es werden Schichtzusammensetzung, Phasenzusammensetzung und Schichtmorphologie mindestens weitgehend unabhängig voneinander mittels Regelung von Parametern des Verdampfungsprozesses eingestellt.

Schichtmorphologie und Kristallstruktur der Schicht sollten vorzugsweise in einem Substrattemperaturbereich zwischen 200°C und 700°C herstellbar sein, damit sie einmal kompatibel sind mit gewöhnlichen Substratmaterialien und zum anderen die Substrattemperatur frei so gewählt werden kann, dass die Anpassung an die verschiedenen Ausdehnungskoeffizienten innerhalb des gesamten Schichtpaketes möglich ist, d.h. man sollte vorzugsweise die Substrattemperatur so wählen können, dass sich Zug- und Druckspannung der Einzelschichten zumindest teilweise kompensieren, beispielsweise in der Mitte des Betriebsbereiches.

Für die erfindungsgemässen Verfahren erfolgt mithin, in einer Variante, das Ablegen der Schicht bei einer Substrattemperatur zwischen 200°C und 700°C.

In einer weiteren Variante der erfindungsgemässen Verfahren wird die Schicht als Schicht in einem Schichtpaket hergestellt.

Die Schichtmorphologie der Festelektrolyteschicht sollte sich vorzugsleise einstellen lassen von dichter Mophology (glassy) bis zu stark kolumnaren Wachstum.

Somit gilt für eine Variante der erfindungsgemässen Verwendung der genannten Verfahren: Es lässt sich die Schichtmorphologie von glasähnlich bis kolumnar einstellen.

Es sollte vorzugsweise die Möglichkeit bestehen, die kubische bzw. tetragonale Phase des ZrO2 auch ohne klassische Stabilisatoren zu synthetisieren, entweder für die Verwendung als Festelektrolyt oder für die Verwendung als Wachstumsunterlage der kubischen bzw. tetragonalen Phase für ein YSZ mit geringem Anteil an klassischen Stabilisatoren, beispielsweise aus Kostengründen für die klassischen Stabilisatoren.

Somit gilt für eine Variante der erfindungsgemässen Verwendung der genannten Verfahren: Es wird die Festelekrolytschicht ohne Stabilisator hergestellt.

Eine Verwendung der genannten Verfahren ist auf die Herstellung der Schicht als Wachstumsunterlage für ein YSZ gerichtet.

Es sollen vorzugsweise einfache Gradientenschichten zwischen der Festelektrolytschicht und den Elektroden einerseits sowie den Interconnects andererseits möglich sein, ohne dass der Beschichtungsprozess unterbrochen werden muss. Im Besonderen bedeutet das, dass vorzugsweise Gradienten zwischen Metallen und Metallnitriden, Metallen und Metalloxiden sowie Metallnitriden und Metalloxiden realisiert werden können sollten.

Somit gilt für eine weitere Variante der erfindungsgemässen Verwendung der genannten Verfahren: Die Schicht wird mit einem Gradienten der Schichtmaterialzusammensetzung in Richtung ihrer Dickenausdehnung hergestellt, vorzugsweise ist der Gradient wie folgt: Von Zr zu ZrN, dann zu ZrO dann zu ZrO2, mit freier Wählbarkeit von Morphologie und Phase.

Mehrfachlagenschichten, die durch Variation im Sauerstoff-Stickstoffgehalt hergestellt werden, werden von den Erfindern als von besonderer Bedeutung angesehen.

In einer Variante der erfindungsgemässen Verfahren wird mithin die Schicht durch Variation des Sauerstoff/Stickstoff -Gehaltes, als Mehrfachlagenschicht hergestellt.

Dabei spielen Übergänge zwischen Metallnitrid und den verschiedenen Metalloxiden eine besondere Rolle, da somit in einem Materialsystem sowohl leitfähige wie isolierende Schichten hergestellt werden können und die Phasen auswählbar sind, was sowohl für die mechanische als auch für die strukturelle Stabilität des Schichtpaketes vorteilhaft ist.

Vorzugsweise sollte eine freie Formierbarkeit des Interfaces/Zwischenschicht zu praktisch allen Materialien möglich sein.

Vorzugsweise sollte, wie erwähnt wurde, die Möglichkeit bestehen sämtliche Schichten in einem Materialsystem zu formieren, welches als metallische Komponente Zirkon umfasst: Zr zu ZrN zu ZrO zu Zr02 mit der freien Wählbarkeit von Morphologie und Phase.

Vorzugsweise findet die Formierung der kubischen oder tetragonalen Phase anders als beim Sintern bei tiefer Substrattemperatur weit entfernt vom thermischen Gleichgewichtszustand statt.

Es ergibt sich somit die Variante der erfindungsgemässen Verfahren, wonach die Formierung der kubischen oder tetragonalen Phase entfernt vom thermischen Gleichgewichtszustand vorgenommen wird.

Von Vorteil kann es sein wenn es möglich ist, das Zr-O Schichtsystems mit anderen Oxiden, die zum Beispiel substratangepasst sind, zu kombinieren.

Auch kann die Möglichkeit der Beimengung von anderen Metalloxiden und Gemischen vorteilhaft sein, um beispielsweise die Ionenleitfähigkeit heraufzusetzen.

Es ergibt sich somit die Variante der erfindungsgemässen Verfahren, wonach Oxyde anderer Metalle als von Zirkonium in das Schichtmaterial eingebaut werden.

Vorzugsweise kann die Kristallitgrösse der Schicht eingestellt werden, insbesondere im Nanometerbereich. Diese geringe Kristallitgrösse erhöht den Ionentransport entlang der Korngrenzen im Vergleich zu Materialien mit grösseren Körnern und resultiert in einer geringeren Abhängigkeit der Ionenleitfähigkeit von der Temperatur.

Somit ergibt sich eine erfindungsgemässe Verwendung der erfindungsgemässen Verfahren für die Erhöhung des Ionentransportes entlang der Korngrenzen wobei die Kristallitgrösse der Schicht vorzugsweise im Nanometerbereich eingestellt wird.

Vorzugsweise sind die Festelektrolyt-Schichtsysteme kombinierbar mit beispielsweise porösen Schutzschichten über der Festelektrolytschicht.

Vorzugsweise gibt es die Möglichkeit zur Erhöhung der mechanischen Stabilität und zum Erzielen einer bestimmten Mikrostruktur durch Beifügen von Al-O, Cr-O, Al-Cr-O, oder weiteren mechanisch stabilen Materialien.

Hinsichtlich dem Herstellungsverfahren sind folgende Anforderungen jeweils vorzugsweise erfüllt:
Vorzugsweise steht ein Verfahren zur Verfügung, das die hohen Sintertemperaturen durch einen Prozess ersetzt, bei dem am Substrat lediglich Temperaturen zwischen 200°C und 700°C notwendig sind.

Vorzugsweise steht ein Verfahren zur Verfügung, das ein problemloses Ankoppeln von mehreren Schichten mit unterschiedlicher Funktionalität an die Festelektrolytschicht zulässt.

Vorzugsweise steht ein Verfahren zur Verfügung, das pulvermetallurgische hergestelltes Material in eine intermetallische Verbindung überführt und diese reaktiv verdampft und als Schicht auf dem Substrat kondensiert.

Vorzugsweise steht ein Verfahren zur Verfügung, welches im Wesentlichen Unabhängigkeit von der Grösse der Ausgangspulver mit sich bringt.

Vorzugsweise steht ein Verfahren zur Verfügung, welches leicht übertragbar ist auf andere Materialsysteme.

Vorzugsweise steht ein Verfahren zur Verfügung, welches eine bessere Möglichkeit der Interfaceformierung bietet als das beim Plasmaspritzen.

Vorzugsweise steht ein Verfahren zur Verfügung, bei dem es nicht zu Regelproblemen kommt wie beim Elektronenstrahlverdampfen.

Vorzugsweise steht ein Verfahren zur Verfügung, welches kostengünstige Technologie anwendet, zu einer Reduktion der Spritzer im Vergleich zum Plasmaspritzen führt und die einfache Prozessausdehnung auf quarternäre Oxide erlaubt.

Vorzugsweise steht ein Verfahren zur Verfügung, welches Targets benutzt, welche mit Standardmethoden beispielsweise im pulvermetallurgischen Verfahren oder Plasmaspritzverfahren in der der für die Schicht gewünschten Zusammensetzungen herstellbar sind.

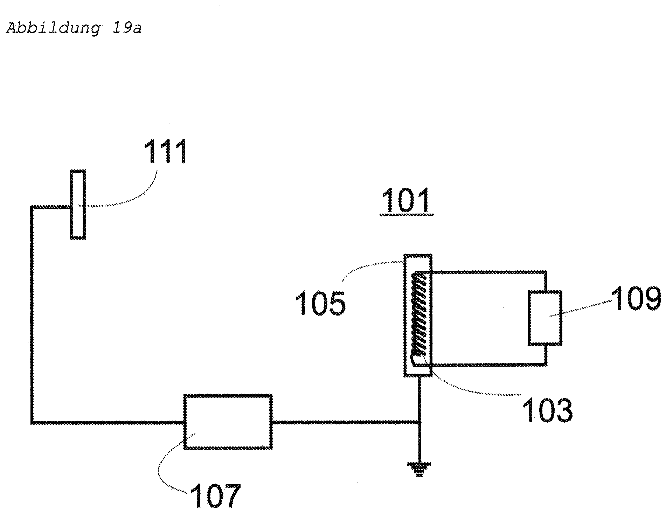

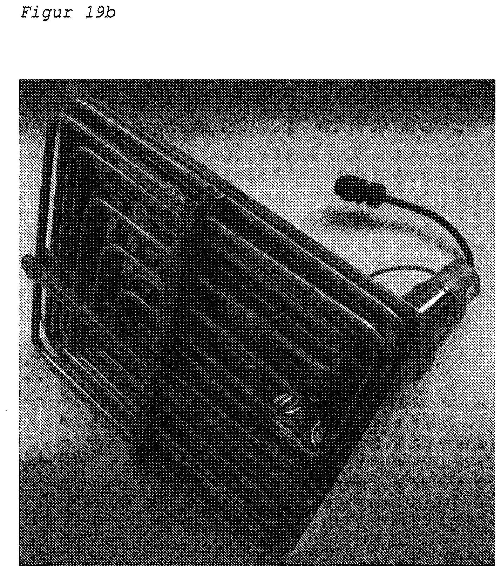

Es soll nun auf eine Besonderheit der für die folgenden Beispiele verwendeten Beschichtungsanlage eingegangen werden, die zu einem besonders stabilen Beschichtungsprozess führt. Im Unterschied zu den Verfahren, die in den oben genannten Druckschriften beschrieben sind und die vor allem das Problem der Oxidbelegung am Target (Kathode der Funkenentladung) bei Prozessen im reinen Sauerstofffluss betreffen, wurde bei den unten aufgeführten Beispielen eine Beschichtungsanlage mit speziell ausgeführter Anode verwendet und dadurch ein weiteres Problem der reaktiven Funkenverdampfung gelöst, welches nicht direkt mit der Herstellung von Zirkonoxidschichten verknüpft ist. Dem Fachmann ist bekannt, dass sich nicht nur das Target, sondern auch die Anode der Funkenentladung im reinen Sauerstoffreaktivgas mit einer Oxidschicht belegen kann. In WO 2009/056173 A1 wurde deshalb eine spezielle Ausführung der Anode (Hohlanode) beschrieben, die die Anodenfläche auch unter der Bedingung des Betriebs der Funkenentladung im reinen Sauerstoffreaktivgas leitfähig hält. Dies führt schon zu recht stabilen Beschichtungsprozessen. Mit dieser Beschreibung soll allerdings ein verbessertes Anodendesign offenbart werden, das für viele Anwendungen in der Produktion einfacher zu realisieren ist und weit weniger Wartungsaufwand erfordert. Eine Ausführungsform dieser Anode 101 ist in Figur 19b dargestellt. Figur 19a zeigt die Anode 101 schematisch als Bestandteil einer Beschichtungsanlage mit Funkenstromquelle 107 der Beschichtungsanlage und Funkenkathode 111. Die Anode 101 umfasst eine beheizbare, elektrisch von Masse getrennter Heizwendel 103, die durch eine zusätzliche elektrische Versorgung 109 gespiessen wird. Die Heizwendel 103 der Anode 101 ist elektrisch isoliert vom Mantel 105 ausgeführt, der entweder auf Massepotential gelegt werden oder floatend betrieben werden kann und zumindest teilweise als Anodenfläche für die Funkenentladung dient.

Eine Anode für eine Funkenverdampfungsquelle, insbesondere zur Ausführung der vorerwähnten Verfahren insbesondere in deren erfindungsgemässen Verwendungen vorgeschlagen, die umfasst:
- Einen Anodenkörper mit einer Anodenfläche,
- entlang der Anodenfläche eine Heizwendel, die vom Anodenkörper elektrisch isoliert ist,
- vom Anodenkörper elektrisch isolierte Anschlüsse für die Heizwendel.

Wie Figur 19b zeigt ist die Anode 101 so ausgestaltet, dass sie sich beim Temperaturwechsel in solchem Umfang verformt, dass die Oxidschichten, die sich auf dem die Oberfläche der Anode bildenden Mantel 105 beim Beschichtungsbetrieb fortwährend aufbauen, bei einem Temperaturwechsel abplatzen.

In einer Variante der Anode ist der Anodenkörper aus Blechmaterial geformt.

Beispielsweise wird eine Funkenverdampfungsanlage mit einer solchen Anode so betrieben, dass man die Anodenfläche, zur mindestens teilweisen Reinigung von einer Störbeschichtung, einem mittels Aktivierung/Desaktivierung der Heizwendel bewirkten Temperaturwechsel aussetzt, derart sich die Anodenfläche verformt und die Störbeschichtung abplatzt.

Durch induzierte Temperaturwechsel kann somit eine ständig frei werdende und leitfähige Anodenfläche garantiert werden. In der Beschichtungsanlage können einige dieser selbstreinigenden Anoden verteilt werden, um die gleichmässige Beschichtung zu garantieren. In einer bevorzugten Variante können diese Anoden so ausgestaltet sein, dass sie auch gleichzeitig als Substratheizung benutzt werden können. In einer weiteren bevorzugten Variante, können diese Anoden durch Blenden vor der direkten Beschichtung durch die Funkenquellen geschützt werden.

Die sich nun anschliessenden Verfahrensbeispiele, die im Folgenden diskutiert werden, wurden mit dieser neuen Anodenanordnung durchgeführt, wobei deren Einsatz nicht zwingend für die Herstellung der Zirkonoxidschichten ist.

Zuerst werden Beispiele zur Synthese von ZrO2-Schichten, die kubische bzw. tetragonale Phasen umfassen angegeben, wobei mit dem Quellenbetrieb analog zu US 20080020138 A1 gearbeitet wurde. Als Funkenquellen wurden für die Haftschichten (SL) ebenso wie für die Funktionsschichten (FL) die Funkenquellen der Firma OC Oerlikon Balzers AG mit Targets, die einen Targetdurchmesser von 160 mm und eine Dicke von 6 mm aufweisen und mit einem Standardmagnetsystem wie beispielsweise in der US_20070000772_A1 beschrieben, verwendet:

### Beispiel 1:

### Schritt (A)

Zuerst erfolgt eine Reinigung der Substrate, auf die die Schicht oder das Schichtsystem aufgebracht werden soll, ausserhalb des Beschichtungssystems. Diese hängt von Substratmaterial und dessen Herstellmethode ab. Meist werden nasschemische Behandlungen, Ausheizen in bestimmten Gasatmosphären oder andere dem Fachmann bekannte Verfahren durchgeführt. In diesem Fall wurde eine nasschemische Behandlung durchgeführt.

### Schritt (B)

Nach Einlegen der Werkstücke in dafür vorgesehenen Halterungen und Einbringen der Halterungen in die Vakuumbehandlungsanlage, wird die Behandlungskammer auf einen Druck von ca. 0.01 Pa abgepumpt.

### Schritt (C)

Danach wird in einem ersten Vakuumvorbehandlungsschritt ein durch Strahlungsheizer unterstütztes Niedervoltbogenplasma zwischen einer durch eine Blende abgetrennte Kathodenkammer mit Heisskathode und den anodisch geschalteten Werkstücken in einer Argon-Wasserstoffatmosphäre gezündet, wobei der Prozessschritt durch folgende Parameter charakterisiert ist:

| | |
|---|---|
| Strom des Niedervoltbogens | 150 A |
| Argonfluss | 50 sccm |
| Wasserstofffluss | 300 sccm |
| Prozessdruck | 1.4 Pa |
| Substrattemperatur | stabilisiert sich bei ca. 500°C |
| Prozesszeit | 45 min |

In diesem Prozessschritt werden die Substrate bevorzugt als Anode für den Niedervoltbogen geschaltet.

### Schritt (D)

In diesem Prozessschritt erfolgt das Ätzen der Substrate, um eine verbesserte Schichthaftung zum Substrat hin zu erzielen. Dafür wird der Niedervoltbogen zwischen dem Filament und einer Hilfsanode betrieben. Bevorzugt werden die Werkstücke mit einer negativen Biasspannung beaufschlagt. Typische Parameter für diesen Schritt sind:

| | |
|---|---|
| Argonfluss | 60 sccm |
| Prozessdruck | 2.4 Pa |
| Strom des Niedervoltbogens | 150 A |
| Substrattemperatur | ca. 500°C |
| Prozesszeit | 30 min |
| Biasspannung | 200 V (für intensivere Ätzeffekte bis zu 1200 V) |

### (E1)

Obwohl das Oxid direkt auf dem Substrat abgeschieden werden kann, soll hier eine Schichtfolge geschildert werden, die sich besonders eignet, um Oxide an metallische Unterlagen anzubinden und die zuerst eine Zwischenschicht oder Stützschicht (SL) verwendet, ehe die eigentliche Funktionsschicht (FL) abgeschieden wird. Dies besteht darin, dass eine erste Schicht aus ZrN auf dem Substrat abgeschieden wird.

Damit ergibt sich eine Variante der erfindungsgemässen Verfahren wobei das Ablegesubstrat eine metallische Oberfläche hat, dahingehend, dass eine Stützschicht auf der metallischen Oberfläche abgelegt wird, dann die Schicht auf die Stützschicht, wobei die Stützschicht vorzugsweise aus einem Metall ausser Zr, einem Nitrid oder einem Oxid besteht, vorzugsweise aus ZrN.

Es werden folgende Parameter verwendet:
Betrieb von 4 elementaren Zr-Targets (natürlich nicht auf diese Zahl beschränkt, eine wesentliche Veränderung der benutzten Targetanzahl muss sich natürlich in einer Anpassung des Drucks bzw. der Sauerstoffflüsse widerspiegeln) mit jeweils 200 A Funkenstrom.

Totaldruckgeregelt auf 3.5 Pa, d.h. es wird Stickstoff über die Flowmeter so geregelt eingelassen, dass sich immer ein Totaldruck von 3.5 Pa in der Beschichtungskammer einstellt.

Substratbias -60 V (wobei Bereiche zwischen -10 V und -1200 V möglich sind), bipolar gepulst mit vorzugsweise 36 µs negativer und 4 µs positiver Pulslänge, was einer Frequenz von 25 kHz entspricht.

| | |
|---|---|
| Substrattemperatur | ca. 500°C |
| Prozesszeit | ca. 5 min |

### (F1)

In einem weiteren Schritt erfolgt der Übergang zur eigentlichen Funktionsschicht, indem über die Flowmeter Sauerstoff zugegeben wird, mit folgenden Prozessparametern:

| | |
|---|---|
| Sauerstofffluss | siehe unten |
| Prozessdruck | 3.5 Pa (weiterhin Totaldruckgeregelt) |
| Funkenstrom | je 200 A für die 4 elementaren Zr Targets |
| Substratbias | -40 V (bipolar) |
| Substrattemperatur | ca. 500°C |
| Prozesszeit | 40 min |

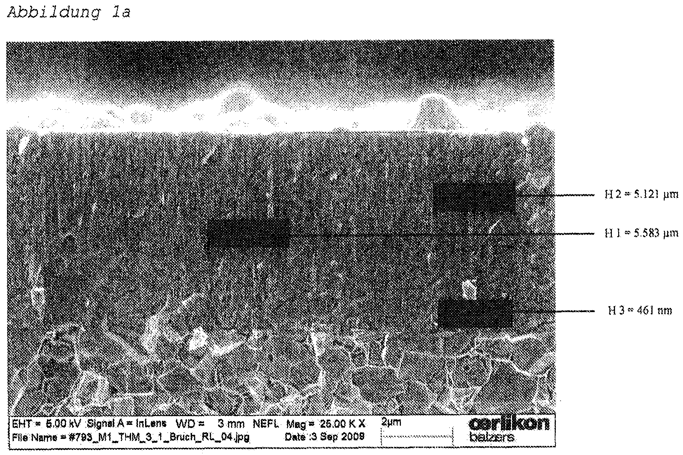

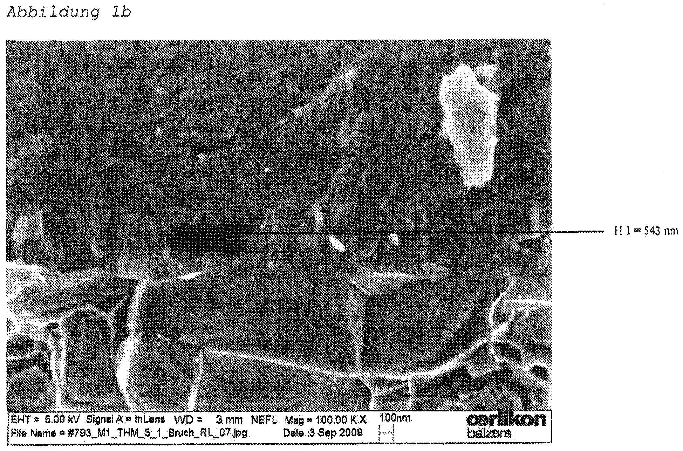

Gibt man wie beschrieben 300 sccm Sauerstoff zu, erhält man eine Schicht, deren Bruchquerschnitt aufgenommen im SEM in Abbildung 1a und b wiedergegeben ist (siehe Probe 793).

Es wurden für Sauerstoffflüsse zwischen 0 und 400 sccm Schichten auf diese Art hergestellt, die in Tabelle 1 beschrieben sind. Die SEM Aufnahmen der Bruchquerschnitte wurden ebenfalls gemacht. Die Abbildungen zeigen folgende Proben:
Abbildung 2: Probe 777 (0 sccm 02)
Abbildung 3: Probe 778 (50 sccm 02)
Abbildung 4a und b: Probe 779 (200 sccm 02)
Abbildung 5a und b: Probe 799 (250 sccm 02)
Abbildung 6a und b: Probe 780 (400 sccm 02).

Der in Beispiel 1 beschriebene Prozess beruht auf der Nutzung von "reinen", d.h. elementaren Zr-Funkentargets ohne klassischem Stabilisator, die in einer reinen Reaktivgasatmosphäre betrieben wurden, d.h. ohne Argon sondern jeweils entweder mit N2 zur Zr-N-Herstellung oder mit Sauerstoff zur Zr-O-Herstellung. In den Schichtübergängen wird mit einem Stickstoffsauerstoffgasgemisch gearbeitet. Der Prozess ist totaldruckgeregelt, d.h. dass Sauerstoffzugabe gleichzeitig Stickstoffrücknahme bedeutet. In der Realität bedeutet das, bei Sauerstofflüssen bis etwa 1000 sccm immer noch Anteile von Stickstoffatmosphäre in der Prozesskammer sind. Im Beispiel wurde Stickstoff als abnehmender Reaktivgaszusatz eingesetzt. die Verwendung von ausschliesslich Sauerstoff führt ab einer gewissen Schichtdicke nachweisbar zur unerwünschten monoklinen Phase bei ca. 350 sccm Sauerstoffzugabe.

### Beispiel 2:

In einer erfindungsgemässen Prozessvariante sollen nun Schichten hergestellt werden, bei denen pulvermetallurgisch hergestellte Legierungstargets (im Beispiel jeweils 2 Stück) mit einer Zusammensetzung von 85 at% Zr und 15 at% Yttrium (Y) als klassischem Stabilisator zur Synthese der Funktionsschicht benutzt werden (siehe auch Tabelle 2). Zur Herstellung der Zwischen- oder Stützschicht wurden aber weiterhin 2 elementare Zr-Targets benutzt:
Zuerst wurden wieder die Teilschritte (A) bis (D) ausgeführt wie sie in Beispiel 1 beschrieben sind.

Zu Vergleichszwecken sollte zunächst wieder eine Schicht ohne Stabilisator erstellt werden (Schritte E1 und F1). Hierzu wurden die zwei Zr(85at%)/Y(15at%)-Targets wieder durch zwei elementare Zr-Targets ersetzt, d.h. es wurden 4 Zr-Targets betrieben, um die Zwischenschicht herzustellen.

### Schritt (E2a)

Dies erfolgte mit folgenden Parametern:

| | |
|---|---|
| Totaldruck (N2) geregelt | 3.5 Pa |
| Funkenstrom | 200 A je Target |
| Substrattemperatur | ca. 500°C |
| Prozesszeit | ca. 5 min |

### Schritt (F2a)

Dann wurde als Schicht eine reine Zr-O-Schicht (ohne Y) abgeschieden, für die also keine Zr-Y-Targets benutzt wurden, d.h. es wurden die 4 Zr-Targets weiterhin betrieben und es wurde wie im Beispiel 1 lediglich Sauerstoff mit einem Fluss von 350 sccm zugegeben, also mit folgenden Prozessparametern gearbeitet:

| | |
|---|---|
| Sauerstofffluss | 350 sccm |
| Totaldruck (N2) geregelt | 3.5 Pa |
| Funkenstrom elementaren Zr-Targets | je 200 A für die 4 |
| Substratbias | -40 V (bipolar) |
| Substrattemperatur | ca. 500°C |
| Prozesszeit | 40 min |

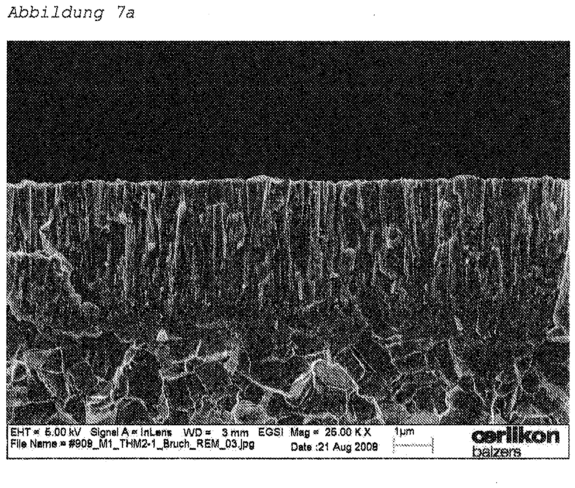

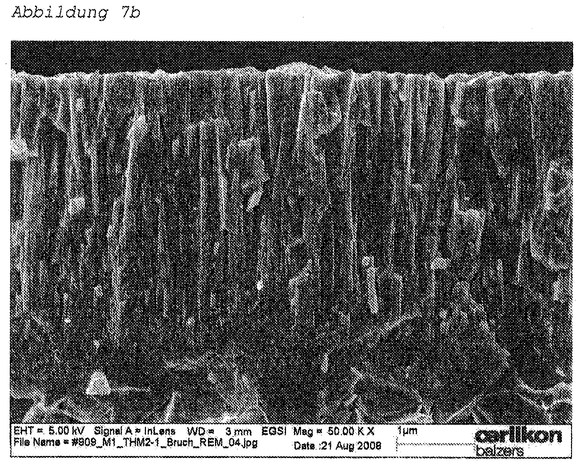

Der Bruchquerschnitt der so erhaltenen Schicht (Probe 909) ist in den Abbildungen 7a und b dargestellt.

Nun sollten in weiteren Versuchen Schichtsysteme mit Yttriumstabilisatoren erstellt werden. Für die weiters hergestellten Schichten (910 bis 912) wurden daher die Schritte (E1) und (F1) folgendermassen modifiziert:

### Schritt (E2b1)

Für diesen Schritt werden nur 2 Zr-Targets in der Beschichtungsanlage belassen und betrieben, um die Zwischenschicht herzustellen. Dies erfolgte mit folgenden Parametern:

| | |
|---|---|
| Totaldruck (N2) geregelt | 3.5 Pa |
| Funkenstrom | 200 A je Target |
| Substrattemperatur | ca. 500°C |
| Prozesszeit | ca. 7 min |

### Schritt (E2b2)

In diesem Schritt wird der Übergang zum Zr-O-N hergestellt:

| | |
|---|---|
| Totaldruck (N2) geregelt | 3.5 Pa |
| Funkenstrom | 200 A je Target |
| Substrattemperatur | ca. 500°C |
| Prozesszeit | ca. 3 min |

Sauerstofframpe von 50 sccm auf Nominalfluss (200 sccm, 300 sccm oder 350 sccm je nach Probe, siehe Tabelle 2) .

### Schritt (E2b3)

Zuschalten der zwei Zr(85 at%)/Y(15 at%) Targets für 2 min mit einem Funkenstrom von 200 A. Daraufhin unverzügliches Abschalten der elementaren Zr -Targets

### Schritt (F2)

Abschalten der zwei elementaren Zr-Targets und Durchführung der Beschichtung mit den beiden Zr(85at%)/Y(15at%) Targets für weitere 80 min und dem Nominalsauerstofffluss nach Tabelle 2.

Für die mit den Sauerstoffflüssen zwischen 200 sccm und 350 sccm hergestellten Schichten nach Tabelle 2, wurden die Schichtbruchquerschnitte wiederum im SEM analysiert. Die Abbildungen zeigen folgende Proben:

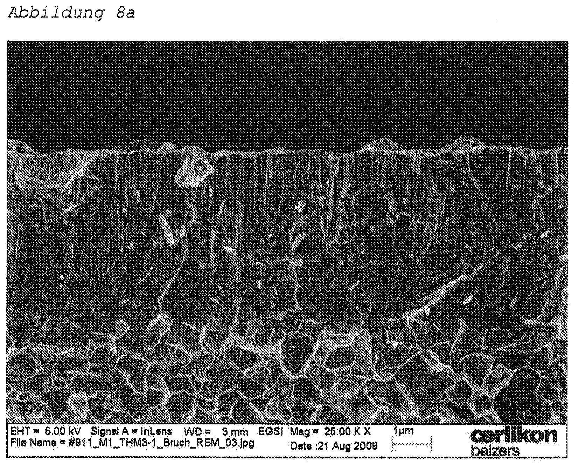

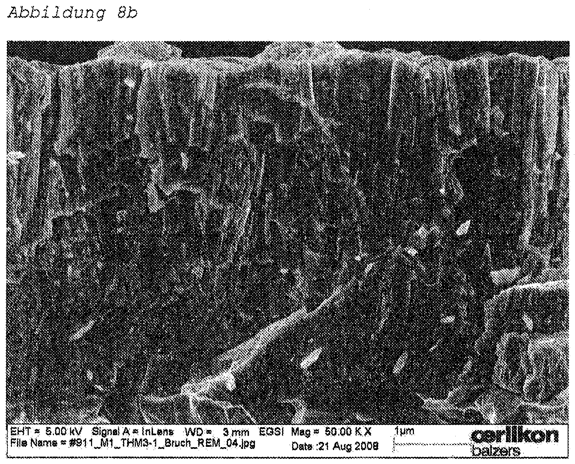

Abbildung 8a und b: Probe 911 (200 sccm 02)

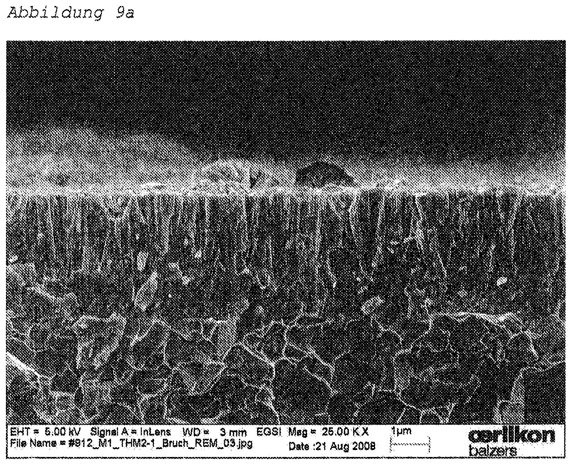

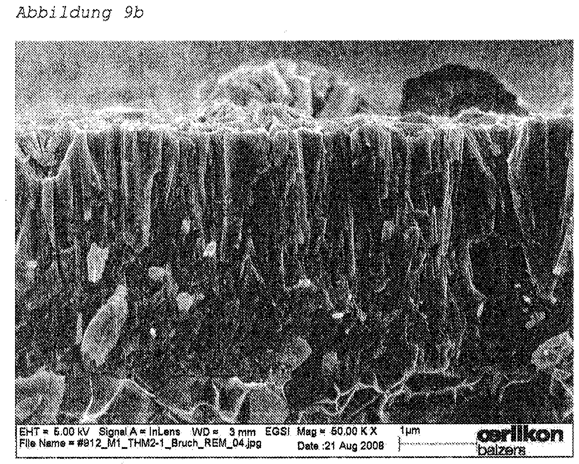

Abbildung 9a und b: Probe 912 (300 sccm 02)

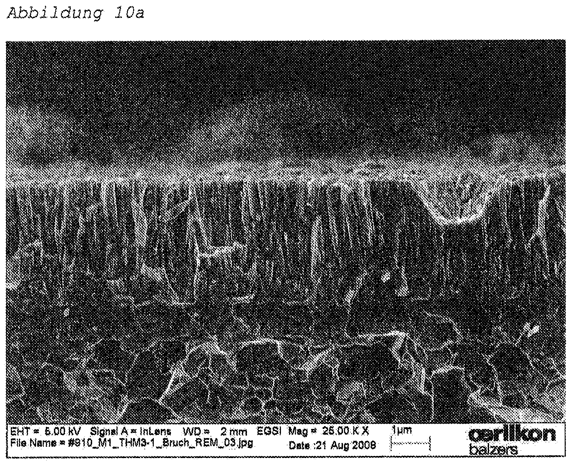

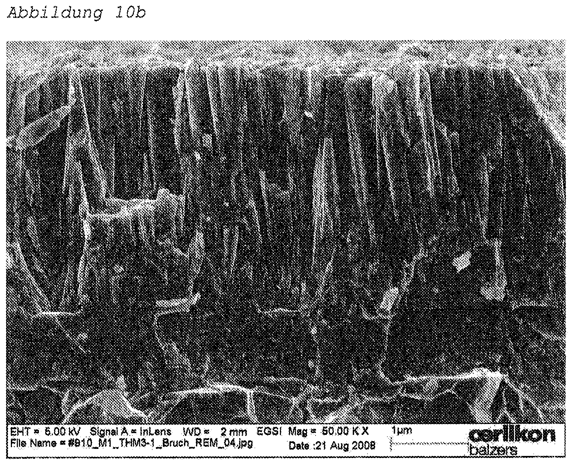

Abbildung 10a und b: Probe 910 (350 sccm 02)

In weiteren Experimenten, die als Beispiel 3 bezeichnet werden sollen, wurde untersucht, wie sich eine gut haftende Zwischenschicht zu Schichtsystemen herstellen lässt, die bereits vor der Beschichtung auf das Substrat mit kubischen oder tetragonalen ZrO2-Schichten abgeschieden wurden. Dabei können diese Schichtsysteme sowohl ausserhalb des Beschichtungssystemes hergestellt worden sein, beispielesweise in einem anderen Beschichtungsprozess, oder auch vorgängig im gleichen Beschichtungssystem.

Es wurden in diesem Zusammenhang eine Vielzahl Schichten untersucht, die typisch sind für Anwendungen als Metallelektroden, als Thermoschutzschichten, als Verschleissschutzschichten und für Sensoranwendungen. Beispielhaft sollen hier nur einige genannt werden: Al, Cr, Ti, Ta, Zr, TiN, ZrN, TiCN, TiAlN, die Oxide von Al, Cr, Ti, Ta, Zr, ternäre und quarternäre Oxide.

In diesem Beispiel 3 soll näher aber ohne Einschränkung auf die Zwischenschichtformierung auf einer TiCN-Schicht eingegangen werden mit anschliessender Zr-O-Funktionsschichtabscheidung.

In den Versuchen wurden dieses Mal für die Zr-O-Funktionsschicht zwei Legierungstargets mit der Zusammensetzung von Zr(92at%)/Y(8at%) benutzt. Die TiCN-Schicht ist eine dem Fachmann bekannte Schicht auf dem Gebiet der Werkzeug- und Komponentenbeschichtung und es kann deren Herstellung als dem Fachmann bekannt vorausgesetzt werden.

Die Ankopplung an die Zr-Y-O-Schicht erfolgt so, dass kurz vor Schluss der TiCN-Schicht, also in der Phase der Ti-Funkenverdampfung in dem Reaktivgasgemisch aus Stickstoff und Kohlenwasserstoff (beispielsweise C2H2) die totaldruckgeregelt verläuft, die beiden Zr(92at%)/Y(8at%)-Targets zugeschaltet werden. Nach wenigen Minuten wird dann das Kohlenwasserstoffgas heruntergerampt und anschliessend die Ti-Targets zur TiCN-Beschichtung abgeschaltet. Schliesslich wird, wieder nach einigen Minuten, Sauerstoff zugegeben und auf den notwendigen Sauerstofffluss gerampt.

Die auf diese Weise hergestellten Schichten sind in Tabelle 4 beschrieben. Es wurde Schichten hergestellt mit Sauerstoffflüssen zwischen 200 sccm und 400 sccm. Auch von diesen Proben wurden wieder Bruchquerschnitte hergestellt und im SEM untersucht.

Die Abbildungen zeigen folgende Proben:

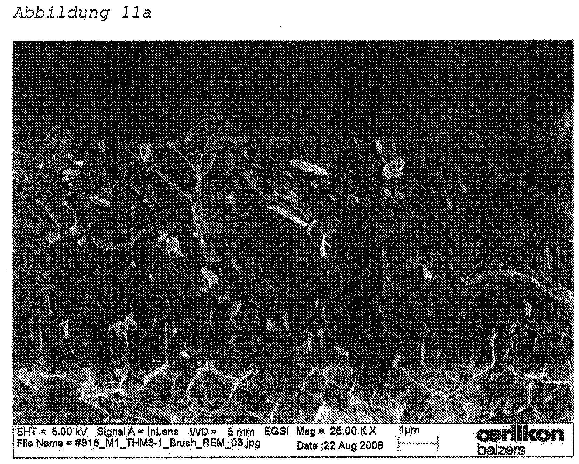

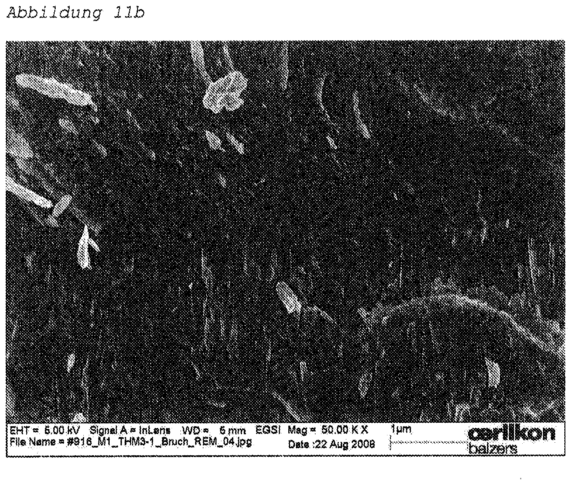

Abbildung 11a und b: Probe 916 (200 sccm 02)

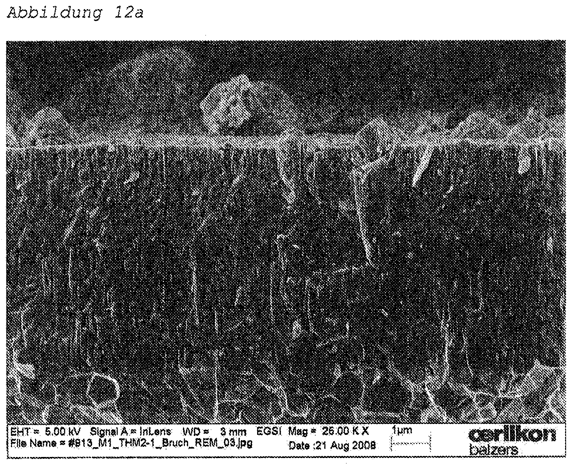

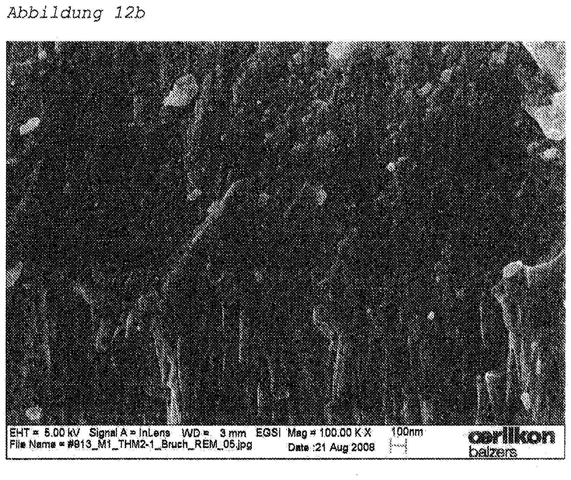

Abbildung 12a und b: Probe 913 (250 sccm 02)

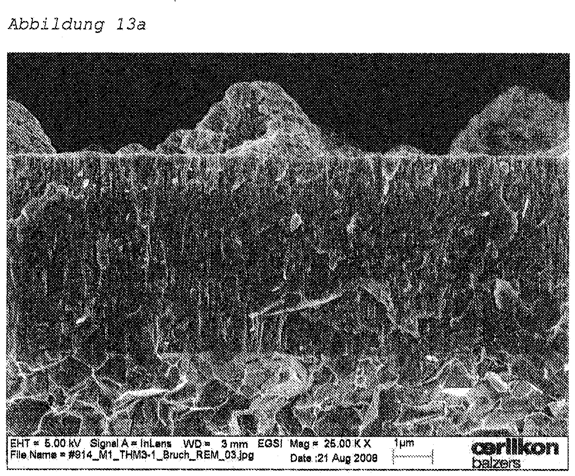

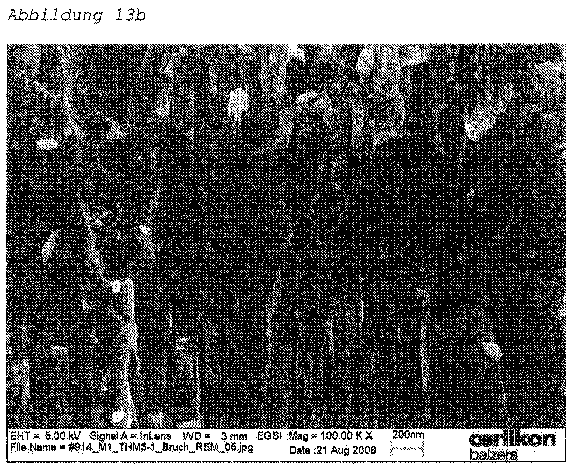

Abbildung 13a und b: Probe 914 (350 sccm 02)

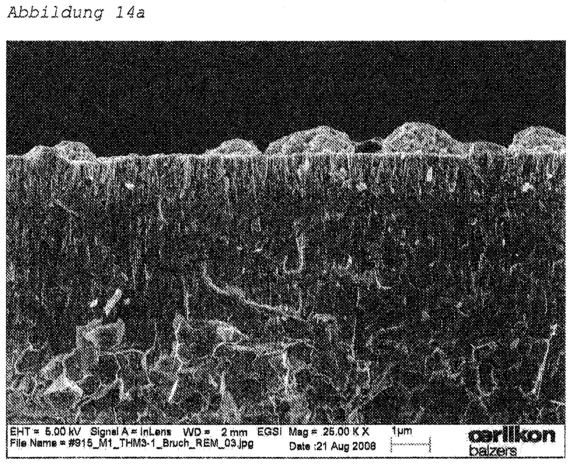

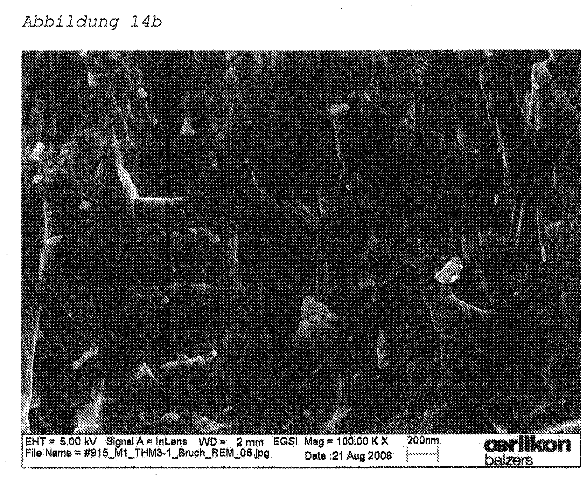

Abbildung 14a und b: Probe 915 (400 sccm 02)

Es sollen nun noch einige weitere Beispiele von Schichten angeführt werden, die auf der Basis der oben erläuterten Beispiele hergestellt wurden, ohne dass allerdings bei jeder Schicht auf die detaillierten Prozessparameter eingegangen wird. Die Schichtbeispiele sollen lediglich dokumentieren, dass mit dem Herstellverfahren die Zr-0-Schichten problemlos an andere Schichtmaterialien angekoppelt werden können und die zusätzlich belegen, dass sich die Morphologie und Schichtstruktur bzw. deren Phasenzusammensetzung leicht mit dem angegebene Herstellverfahren beeinflussen lässt.

Folgende Abbildungen zeigen von diesen Schichten die Bruchquerschnitte, die im SEM analysiert wurden:

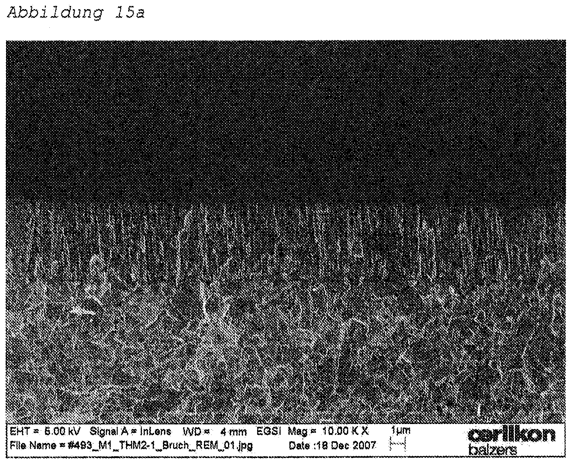

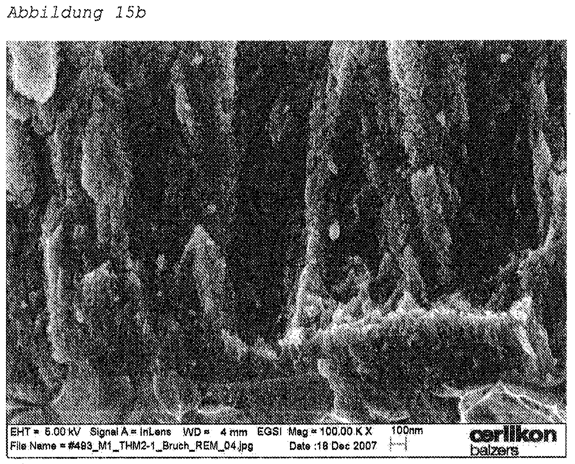

Abbildung 15a und 15b zeigen eine dicke Zr-O-Schicht (Probe 493), die auf einer Chrom-Chromoxid-Zwischenschicht aufgebracht wurde.

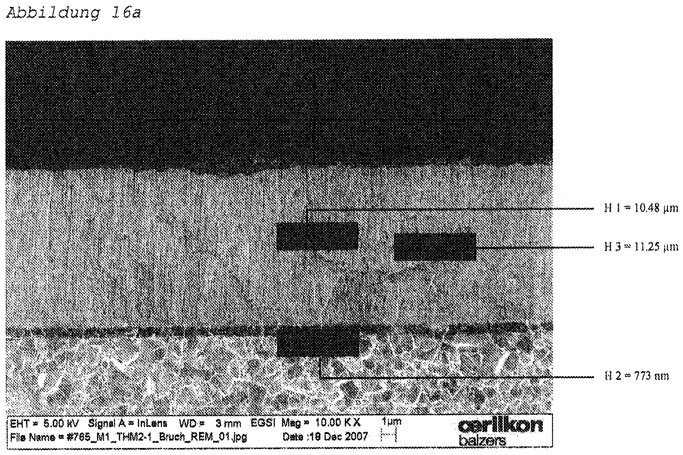

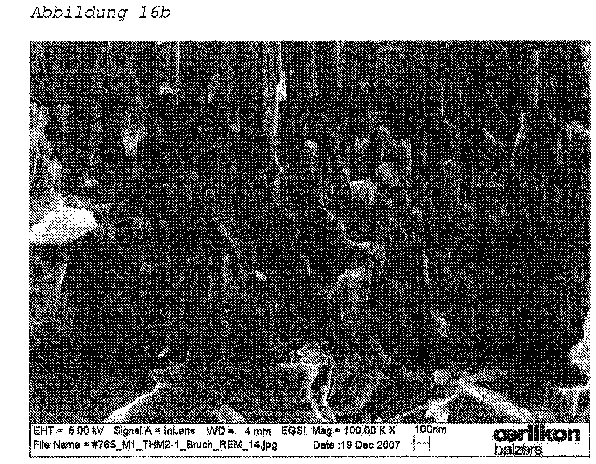

Abbildung 16a und 16b zeigen die Mikrostruktur einer Zr-O-Schicht hergestellt mit elementaren Zr-Targets und mit einem hohen Sauerstofffluss von 600 sccm. Als Interface wurde ein dünnes TiCN von ca 500 nm gewählt.

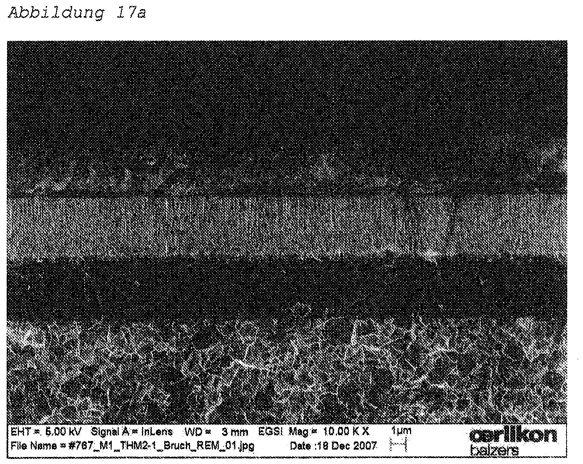

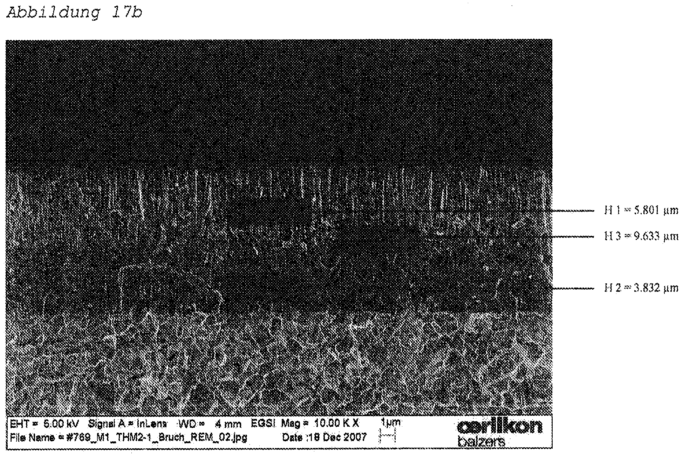

Abbildung 17a und b zeigen den Vergleich von Zr-O-Schichten abgeschieden auf einer dickeren TiCN-Schicht von ca. 3.5 µm, wobei 17a (Probe 767) nach US_20080020138_A1 betrieben wurde, 17b (Probe 769) jedoch gepulst wie es in US_20070000772_A1 beschrieben ist.

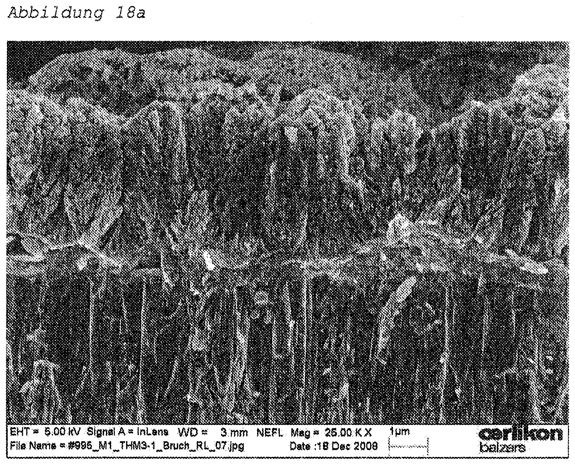

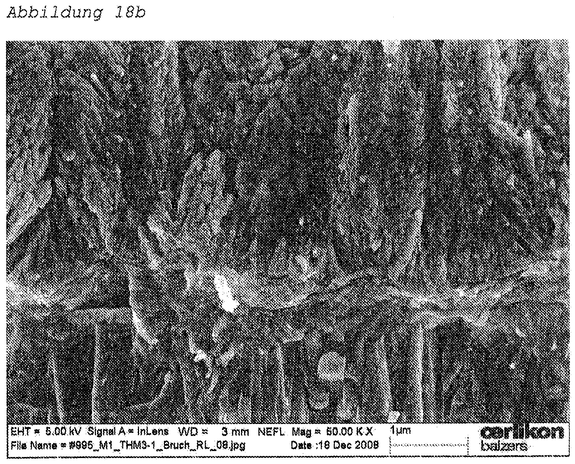

Abbildung 18a und b (Probe 995) zeigen eine weitere SEM-Analyse eines Bruches an einer Probe, bei der auf einer dicken CrN-Schicht eine Zr-Y-O-Funktionsschicht mittels Zr(92at%)/Y(8at%)-Targets abgeschieden wurde.

Die mit den oben beschriebenen beispielhaften Verfahren hergestellten Schichten wurden analysiert und sollen nun näher beschrieben werden.

Zuerst werden die Schichten aus Beispiel 1 diskutiert, die in Tabelle 1 beschrieben werden. Zum einen beruht die Auswertung auf XRD-Messungen unter streifendem Strahleinfall von 1, was bei einer Gesamtschichtdicke der untersuchten Schichten von ca. 5 µm den Einfluss des substratnahen Schichtbereiches und damit des SL nahezu ausschliesst oder stark unterdrückt.

Um die Zusammensetzung der Schicht zu ermitteln wurden andererseits zusätzlich RBS und ERDA (Elastic Recoil Detection Analysis) Analysen durchgeführt. Auch diese Ergebnisse wurden in Tabelle 1 eingetragen.

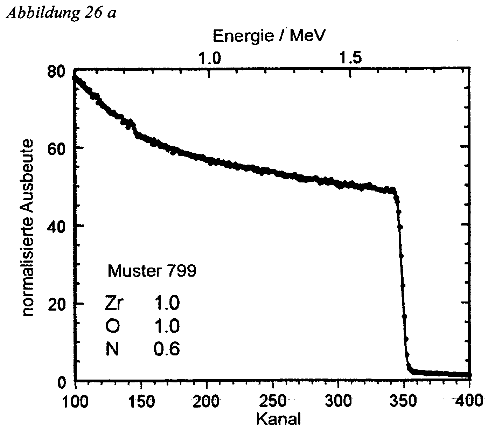

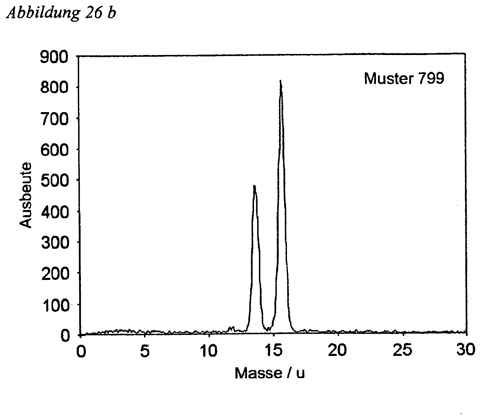

Für die Probe 799 wurde in Abbildung 26a beispielhaft ein RBS-Spektrum dargestellt, das nach der Analyse auf eine Schichtzusammensetzung von Zr₁O₁N_{0.6} hindeutet. Das Verhältnis von Stickstoff und Sauerstoff für diese Probe wurde genauer mittels ERDA ermittelt. Die entsprechende Messung ist in Abbildung 26b dargestellt.

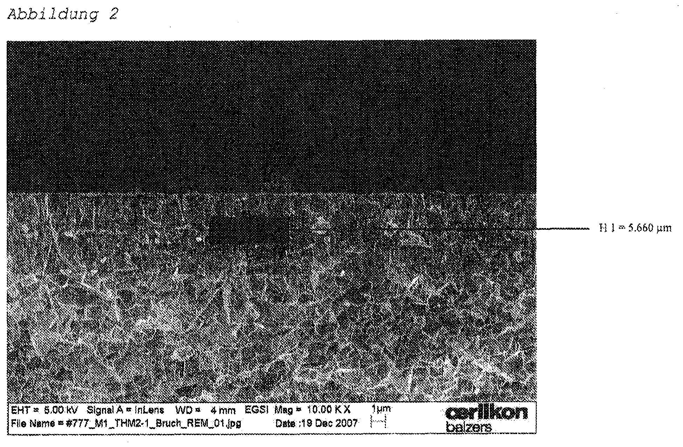

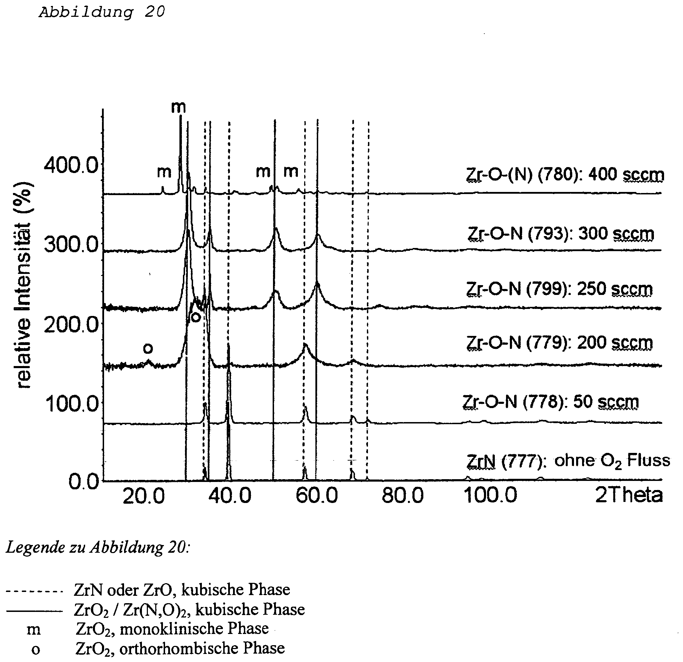

Für die Probe 777 (Abbildung 2) wurden die 4 Zr-Targets in reinem Stickstoff betrieben. Das XRD-Spektrum (Abb. 20) zeigt die Bragg Peaks von ZrN mit kubischer Struktur (a=4.575 Å). Die Analyse der Schicht mittels RBS ergab eine Zusammensetzung, die durch Zr1N1.1 beschrieben werden kann und die auf keine anderen Schichtbestandteile hinweist. Die 10% "Überstöchiometrie" des Stickstoffs liegen im Fehlerbereich für die leichten Elemente der RBS-Methode. Dieser Fehlerbereich war auch der Grund, dass für eine genauere Bestimmung des Sauerstoff-Stickstoff-Verhältnisses (O/N) bzw. (N/O) (Ergebnisse ebenfalls in Tabelle 1) eine ERDA Analyse für O und N an den Proben durchgeführt wurde.

Mit der Zugabe von Sauerstoff von 50 sccm (Probe 778) und 200 sccm (Probe 779) bleibt im Wesentlichen die kubische Struktur nach dem XRD erhalten. Für die Schichtzusammensetzung erhält man ein O/Zr Verhältnis von 0.12 bei 50 sccm (Probe 778), das auf 0.74 bei 200 sccm (Probe 779) steigt, d.h. in beiden Fällen wird Sauerstoff in die Schicht eingebaut zusätzlich zum Stickstoff. Trotz Beibehaltung der kubischen Struktur kommt es aber für beide Proben zu einer Verbreiterung der Bragg Peaks, die ein Hinweis ist auf die Bildung von kubischem ZrO (a=4.62) oder Zr(O,N) oder Zr02-x oder von Gemischen aus diesen Phasen. Bei 200 sccm gibt es Peaks, die auf kleine Anteile orthorombischer Phase des Zr02 neben der Existenz der kubischen Phase des ZrO Monoxids hinweisen.

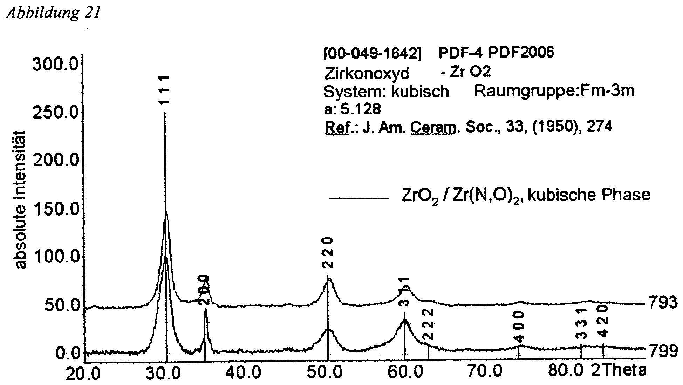

Ab 250 sccm (Probe 799) kommt es zu einer Formierung der kubischen bzw. tetragonalen Phase, wohl zu einem Phasengemisch, was die (111) und (200) Peaks verdeutlichen, vergrössert dargestellt im XRD-Spektrum in Abb. 21. Diese beiden Phasen lassen sich bei kleineren Kristallitgrössen kaum auf der Basis des XRD-Spektrums trennen.

Bei 300 sccm erhöht sich die Kristallinität dieser Phase bzw. dieses Phasengemisches, das dann aber bei 400 sccm deutlich in die monokline Phase umschlägt mit Anteilen von kubischen bzw. tetragonalen Phasen. Mit der Erhöhung des Sauerstoffflusses einher geht die Erhöhung des O/Zr Verhältnisses bzw. die Erniedrigung des N/Zr Verhältnisses (Tabelle 1).

Als ein Ergebnis dieser Messungen kann man zusammenfassend sagen, dass mit dem oben beschriebenen Beschichtungsprozess der reaktiven Funkenverdampfung unter Benutzung von elementaren Zr-Targets ein Übergang vom kubischen ZrN zum Gemisch von kubischem ZrN/kubischen ZrO (Monoxid) und schliesslich zur kubischen bzw. tetragonalen Phase oder des Phasengemisches des kubischen ZrO2 realisiert werden kann, d.h. dass der Stickstoff oder das kubische ZrN als eine Art neuer "Stabilisatoren" wirken, um die kubische bzw. tetragonale Phase des Zr02 zu erzielen.

Besonders vorteilhaft ist der Sachverhalt, dass man den gesamten Übergang allein durch die Änderung des Sauerstoffgasflusses bei gleichzeitiger Regelung auf den Totaldruck erreichen kann, also ein sehr einfacher Prozess entwickelt wurde, um ohne die bisher in der Literatur bekannten Stabilisatoren kubisches bzw. tetragonales ZrO2 herstellen zu können.

Als weiteres Ergebnis kann Folgendes festgehalten werden: Einmal kann man durch das periodische Einlassen geringer Sauerstoffflüsse ein Multilagensystem von ZrN/Zr(O,N) aufbauen (analog Probe 777/779), das vollständig kubische Phase aufweist, also immer zwischen kubischen ZrN und kubischen Zr(O,N) wechselt.

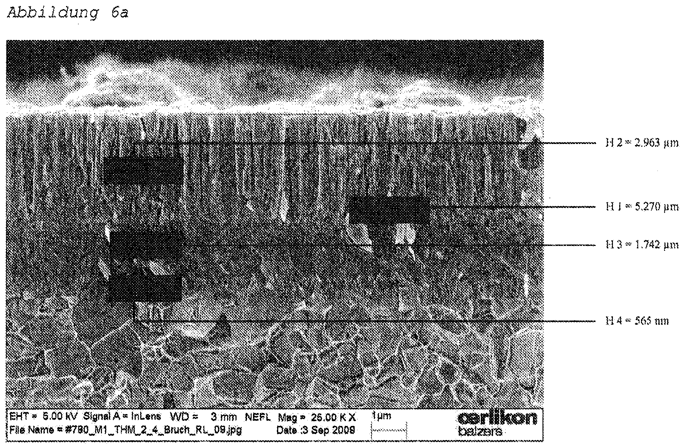

Andererseits kann man diese Multilagensysteme auch in dem Bereich des Sauerstofflusses synthetisieren, wo sich gerade der Übergang zwischen Stickstoffstabilisierung und der Bildung der monoklinen Phase befindet und so eine Multilagenstruktur zwischen kubischer bzw. tetragonaler Phase des Zr02 (mit Anteilen von kubischen Zr(O,N)) mit und ohne Stickstoffanteil aufbauen. Bedingung dafür ist allerdings, dass diejenigen Schichten ohne Stickstoff so dünn gehalten werden, dass noch kein Umklappen in die monokline Phase erfolgt. Abbildung 6a (Probe 780) zeigt, obwohl die gesamte Schicht mit einem Sauerstofffluss von 400 sccm hergestellt wurde, einen Morphologiewechsel nach etwa 1.7 µm der FL von einer dichten in eine Säulenstruktur. Dieser Wechsel geht einher mit der Phasenänderung der kubischen bzw. tetragonalen Struktur zur monoklinen Struktur. D.h. also, dass man über längere Zeit kubisches bzw. tetragonales Schichtwachstum erzielen kann, ohne Stickstoff in die Schicht einzubauen (Tabelle 1, Probe 780). Oder mit anderen Worten gesagt: die N-Stabilisierung führt dazu, dass die Schicht eine zeitlang noch durch die unterliegende Schicht mit Stickstoffgehalt stabilisiert wird, ohne selbst Stickstoff aufzuweisen.

Und noch ein weiterer Aspekt dieses Prozessansatz kann für die Anwendung bedeutungsvoll sein: Die Möglichkeit über eine ZrN-Schicht die Zr-O-Schichten an das darunterliegende Substrat oder Schichtsystem gradientenhaft gut anzuschliessen, weil damit eine gute Haftung zu metallischen Substraten oder Schichten erreicht werden und ein Schichtwachstum basierend auf nur einem Materialsystem realisiert werden kann.

Die Abbildungen der Bruchquerschnitte von den SEM Untersuchungen demonstrieren dies. Beispielsweise zeigen 1b, 4b und 6b den innigen Verbund der ca. 500 nm dicken ZrN-Zwischenschicht (SL) zu der Funktionsschicht (FL), während 18b auf eine deutlich schlechtere Haftung hinweist, da die Rampe in den hohen Sauerstoffgehalt des ZrO2 nur sehr kurz gehalten wurde.

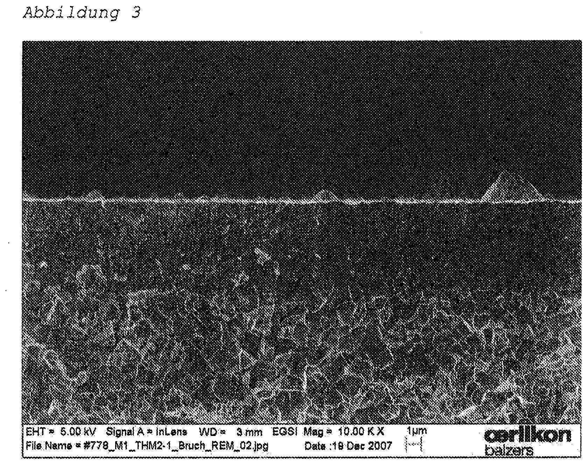

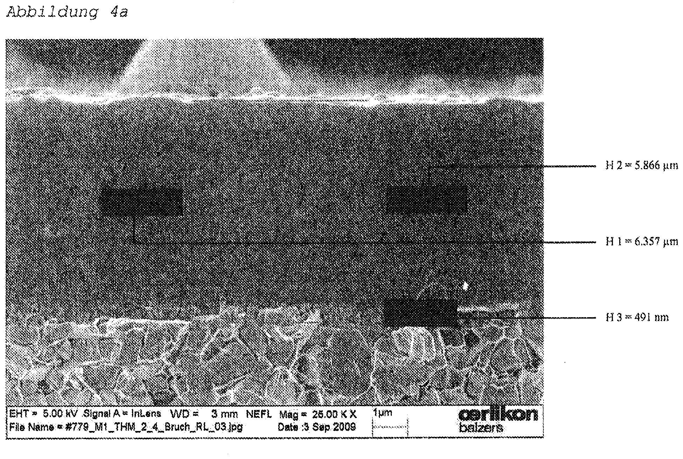

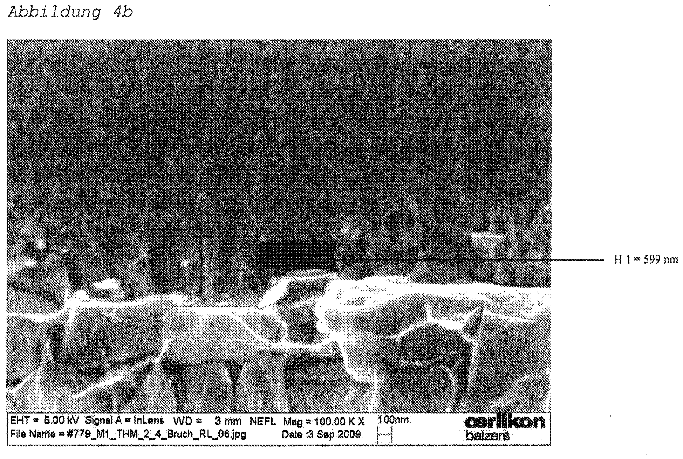

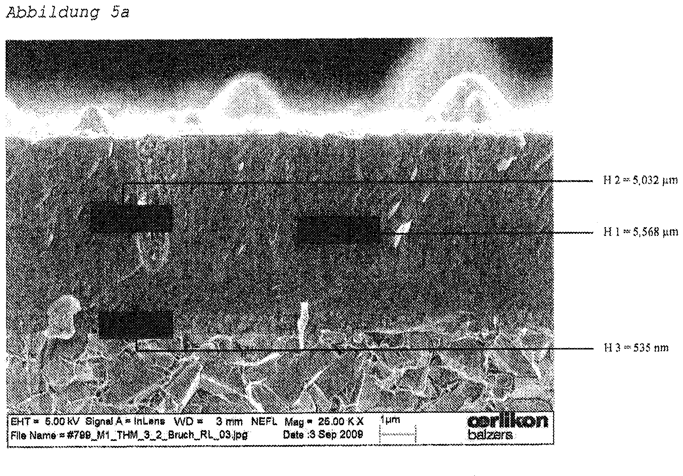

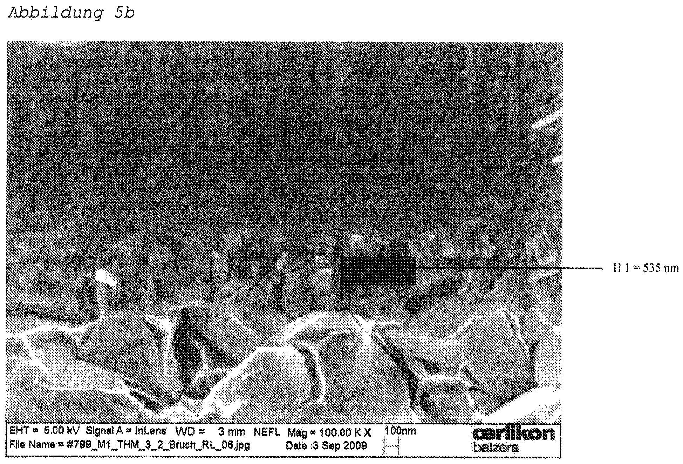

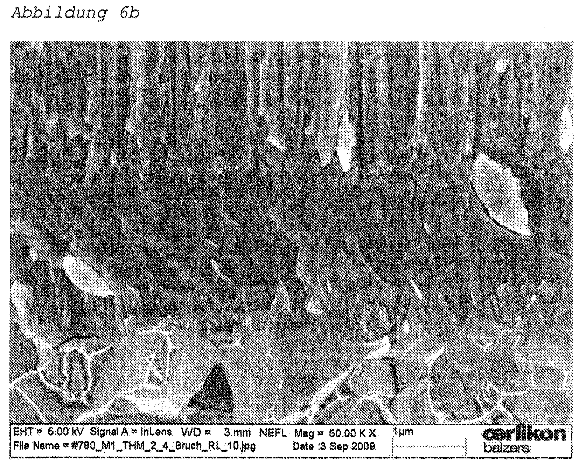

Die Analyse an den Schichten aus dem Beispiel 1 zeigt noch ein erstaunliches Ergebnis: Die Schichtmorphologie ändert sich mit dem Sauerstofffluss. Während das ZrN (Abb. 2) sehr kompakt ist, wird die Schicht anfangs mit Sauerstoffzugabe sehr feinkörnig oder amorph (Abb. 3 und 4). Das weitere Erhöhen des Sauerstoffflusses führt zunehmend zu ausgeprägteren vertikalen Strukturen im Schichtwachstum (Abb. 5 und 1), das schliesslich in Säulenstruktur übergeht (Abb. 6). Diese Resultate erlauben beispielsweise Anwendungen, in denen man beispielsweise die härtere kubische Phase mit einer weicheren monoklinen Phase (analog Abb. 6) des ZrO2 bedeckt, um beispielsweise tribologische Systeme wie Einlaufvorgänge bei Turbinenschaufeln oder bei anderen Komponenten im Bereich der Verbrennungsmotoren mit dem Ziel der Reduzierung des Gegenkörperverschleisses zu optimieren.

Andererseits wäre es oft auch wünschenswert, dass die Schichtmorphologie geändert werden kann, ohne dass sich dabei die Phasen ändern. Voraussetzung dafür ist es, dass stabile Phasen erzeugt werden, die nicht oder wenigstens in grossen Bereichen unabhängig vom Sauerstofffluss sind.

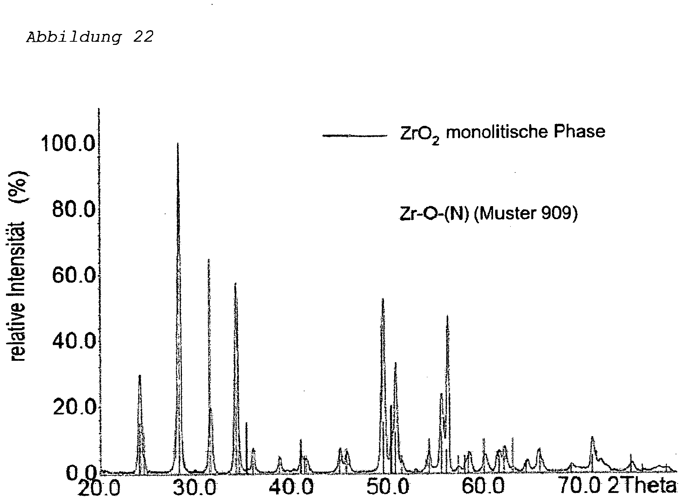

Das war eine Motivation für die erfindungsgemässen Prozessentwicklungen, die nach Beispiel 2 durchgeführt wurden und deren Ergebnisse in Tabelle 2 zusammengefasst sind. Bei der Probe 909 wurde noch einmal mit 4 elementaren Zr-Targets gearbeitet und auf einer Zwischenschicht von wieder ca. 500 nm ZrN eine Zr-O-N-Schicht mit einem Sauerstofffluss von 350 sccm abgeschieden. Das XRD-Spektrum dieser Schicht in Abb. 22 zeigt deutlich die Bragg Peaks der monoklinen Phase des ZrO2. Das ist in Übereinstimmung mit den Ergebnissen der Schichten, die nach dem Beispiel 1 hergestellt wurden und bei denen zwischen einem Sauerstofffluss von 300 sccm und 400 sccm das "Umklappen" der kubischen bzw. tetragonalen Phase in die monokline Phase erfolgte. Die Schicht zeigte trotz des Stickstoffhintergrunddrucks (Totaldruckregeleung) keinen Stickstoffanteil in der Schicht nach ERDA, d.h. der N-Gehalt ist kleiner 1 at%. Auch das ist etwa konsistent mit den Proben aus Beispiel 1, bei denen bei 400 sccm kein N mehr in der Schicht gefunden wurde. Die Morphologie der Schicht (Abb. 7) ist ebenfalls vergleichbar mit der der Probe 780, zumindest im oberflächennahen Bereich, und zeigt Säulenstruktur.

Die weiteren Schichten in Tabelle 2 wurden nun so hergestellt, dass die Zwischenschicht von 2 reinen Zr-Targets synthetisiert wurden, während für die Funktionsschicht (FL) 2 Zr(85 at%)/Y(15at%)-Targets benutzt wurden. Der Sauerstofffluss wurde nun variiert mit dem Ziel, die Schichtmorphologie zu verändern.

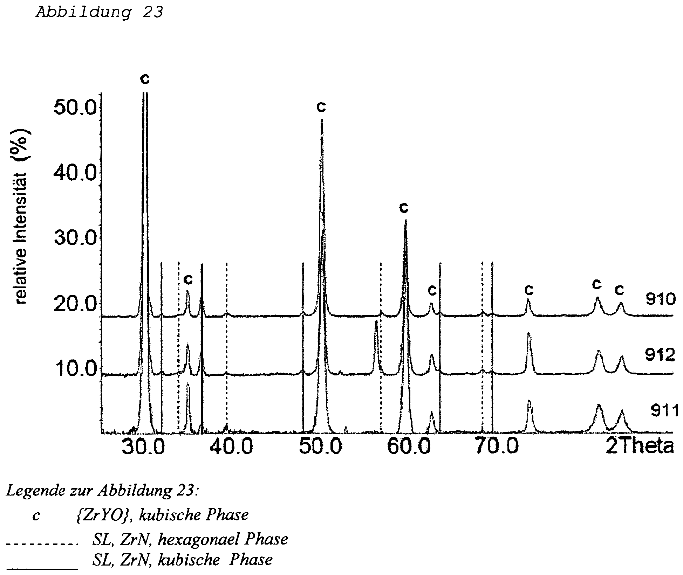

Für Probe 911 (200 sccm) sieht man in Abb. 8 eine relativ kompakte Schichtmorphologie. Bei weiterer Erhöhung des Sauerstoffflusses zeigen die Schichten immer deutlicheres Säulenwachstum (Proben 912 und 910 in Abbildungen 9 und 10). Die XRD-Spektren der Proben, bei denen die FL mit den Zr/Y-Targets hergestellt wurden, sind in Abb. 23 abgebildet.

Für alle Schichten, unabhängig vom Sauerstofffluss, sieht man die Bragg Peaks der kubischen Struktur des ZrO2. Wenige Bragg Peaks mit geringer Intensität stammen vermutlich von der ZrN Zwischenschicht (kubische und hexagonale Phase). Eine detalliertere Analyse der Peaks, die von der kubischen Phase bei 2Θ ≈ 30° und bei 2Θ ≈ 50° stammen, ist in Tabelle 3 angefügt. Daraus liest man ab, dass es mit steigendem Sauerstofffluss zu einer höheren Kristallinität (grössere Kriatallite) kommt, da die FWHM kleiner wird (FWHM - Full Width at Half Maximum). Da man in den Spektren auch nirgends die Andeutung eines Peaks bei 2Θ ≈ 43° erkennen kann und das typisch wäre für die tetragonale Phase des ZrO2 und welches man bei dieser erhöhten Kristallinität sehen müsste, kann man schliessen, dass im Wesentlichen bei all diesen Proben nur kubische Phasen des ZrO2 vorliegen und keine tetragonalen. Es sei hier auch erwähnt, dass aufgrund des klassischen Stabilisators auch bei wesentlich höheren Sauerstoffflüssen (z. B bei 1500 sccm Sauerstofffluss) die kubische Phase erhalten bleibt und nicht in die monokline Phase umschlägt.

Damit ergeben sich folgende wichtige Resultate aus den Untersuchungen. Das Einbringen eines klassischen Stabilisators wie er aus den Sinter- und anderen Verfahren her bekannt ist, in das Target, das zur Funkenverdampfung benutzt wird, führt zur Stabilisierung der tetragonalen und kubischen Phase des ZrO2. Benutzt man Y als Stabilisator, wird diese kubische Phase bei Y-Targetbestandteilen von mehr als 8 at% deutlich sichtbar im XRD erreicht. Unterhalb dieser Konzentration findet man in der Schicht ein Phasengemisch aus kubischer und tetragonaler Phase (siehe die Untersuchungen weiter unten). Die kubische Phase ändert sich nicht mit einer Erhöhung des Sauerstoffflusses, wie das für die Proben nach Beispiel 1 der Fall war. In den Schichten wird, im Gegensatz zu den Schichten nach Beispiel 1, schon bei 200 sccm Sauerstofffluss kein Stickstoff mehr eingebaut, obwohl auf den Totaldruck von 3.5 Pa geregelt wurde. Unter diesen Bedingungen muss man beispielsweise für einen Sauerstofffluss von 300 sccm einen Stickstofffluss von etwa 800 sccm annehmen, um den Totaldruck von 3.5 Pa zu erreichen, d.h. man hat wesentlich mehr Stickstoff in der Anlage, baut diesen aber nicht in das Zr02 ein.

In Beispiel 3 wurden nun Zr-Y-O-(N) Schichten erfindungsgemäss hergestellt, die in Tabelle 4 beschrieben sind. Für diese Beispiele wurde eine "materialfremde" Schicht, nämlich TiCN als Zwischenschicht (SL) gewählt. Der Übergang in die Zr-Y-O-N-Schicht wurde wieder über die Totaldruckregelung gefahren. Es wurden aber dieses Mal Zr(92at%)-Y(8at%)-Targets benutzt.

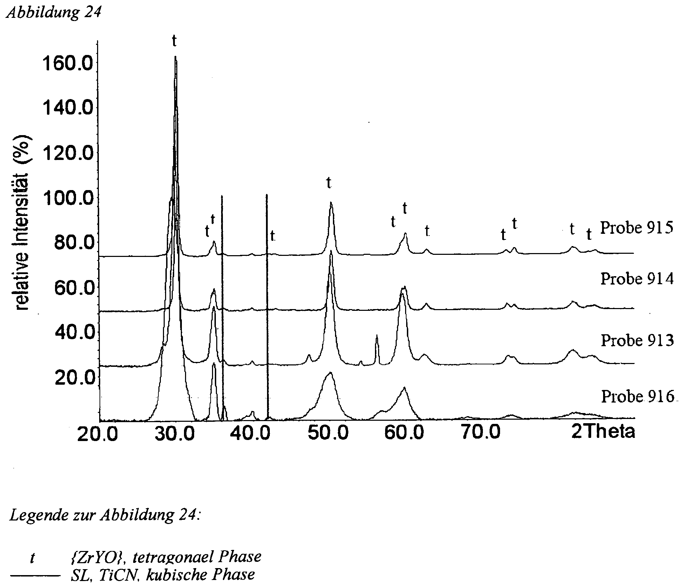

Die Ergebnisse der XRD-Messungen sind in Abb. 24 dargestellt. Alle Schichten weisen auf eine dominante tetragonale Phase hin, da die Bragg Peaks bei 2Θ = 43° und das Splitting des Peaks bei etwa 2Θ = 60° sichtbar sind, das bei der rein kubischen Phase nicht auftritt. Anteile der kubischen Phase in diesen Schichten können allerdings nicht ausgeschlossen werden. In Tabelle 5 sind die FWHM der Bragg Peaks bei 2Θ = 30° und bei 2Θ = 50° für die verschiedenen Sauerstoffflüsse angegeben. Auch für diese Untersuchungen beobachtet man also eine erhöhte Kristallinität mit steigendem Sauerstofffluss. Auch mit nur 8at% Y in den Targets wurde die Schicht so stabilisiert, dass selbst bei höheren Sauerstoffflüssen keine monokline Phase erzeugt wurde, sondern die tetragonale Phase (mit eventuellen kubischen Anteilen) stabil blieb.

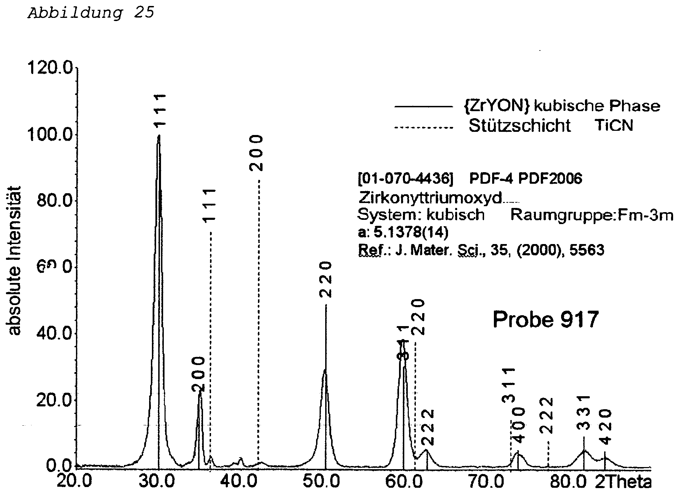

Für die Probe 917, deren XRD Spektrum in Abbildung 25 gezeigt ist, und deren Prozessparameter und Analyse teilweise in Tabelle 4 aufgeführt sind wurde eine ausgeprägte, d.h. dickere kubische Zirkonnitridschicht gefahren. Dies führte zur vorwiegend kubischen Phase von ZrO2 wie die ausgeprägten Peaks im XRD-Spektrum der Abbildung 25 zeigen. Man beachte, dass das für die tetragonale Phase typische Splitting des Peaks bei 60° nicht vorhanden ist.

Abschliessend sollen noch andere Schichtbeispiele diskutiert werden, die nach den obigen Verfahren hergestellt wurden.

Abbildung 15 zeigt den SEM Bruchquerschnitt einer dicken Zr(Y8at%)O2-Schicht (Probe 493) mit tetragonaler Struktur, aufgebracht auf einer Chrom-Chromoxid-Zwischenschicht. Zur Beschichtung wurden Zr(92at%)/Y(8at%)-Targets benutzt und es wurde mit einem sehr hohen Sauerstofffluss von 1500 sccm beschichtet. In diesem Prozess wurde keine Totaldruckregelung benutzt, sondern bei der Verdampfung von den Zr(92at%)/Y(8at%)-Targets mit konstantem Sauerstofffluss gearbeitet.

Dies illustriert, dass als Zwischenschicht auch ein Oxid benutzt werden kann, hier das Chromoxid, um "verwandte" Materialien aneinander zu binden. Das kann sinnvoll sein, wo beispielsweise die thermischen Ausdehnungskoeffizienten aneinander angepasst werden müssen, von denen sich viele bei den Oxiden ähnlich sind.

Man sieht aus der Abbildung, dass der hohe Sauerstofffluss die Säulenstruktur in eine noch weniger dichte Morphologie überführt mit hoher Porosität und entsprechend grosser Oberfläche. Eine solche Oberfläche eignet sich besonders gut für Anwendungen im Sensorbereich, da sie sowohl zur schnelleren Diffusion der zu detektierenden Spezies beiträgt und auch die Empfindlichkeit erhöht. Das XRD Spektrum (nicht abgebildet) zeigt die Bragg peaks der tetragonalen Struktur mit Anteilen der kubischen Phase, und zeigt, dass auch ohne die Totaldruckregelung im Stickstoff die tetragonale bzw. kubische Phase hergestellt werden kann.

Abbildung 16 zeigt die Mikrostruktur einer ZrO2-Schicht hergestellt von elementaren Zr-Targets und mit einem ebenfalls hohen Sauerstofffluss von 600 sccm. Als interface wurde ein dünnes TiCN von ca 500 nm gewählt. Wieder wurde lediglich auf den Sauerstofffluss geregelt und nicht auf den Totaldruck mit Stickstoffhintergrunddruck. Die Schicht weist die monkline Phase auf. Obwohl sie nicht die bevorzugte tetragonale oder kubische Struktur hat, eignet sie sich zum Schutz von Substraten vor allem in Verbindung als Einlaufschicht bei höheren Temperaturen, um den Gegenkörper nicht zu verschleissen.

Abbildung 17a und b zeigen den Vergleich von Zr02-Schichten abgeschieden auf einer dickeren TiCN-Schicht von ca. 3.5 µm, wobei 17a (Probe 767) nach US 20080020138 A1 betrieben wurde, 17b (Probe 769) jedoch gepulst wie es in US 20070000772 A1 beschrieben ist. Es wurden elementare Zr-Targets verwendet. Die Mikrostruktur der Schichten zeigt einen deutlichen Unterschied. Es gibt stärker kristallines Wachstum bei 17b. Für beide Schichten weisen die XRD-Spektren (nicht gezeigt) auf die monokline Phase hin.

Abbildung 18a und b (Probe 995) zeigen eine weitere SEM-Analyse eines Bruches an einer Probe, bei der auf einer dicken CrN-Schicht eine Zr-Y-O-Funktionsschicht mittels Zr(92at%)/Y(8at%)-Targets abgeschieden wurde. Wieder wurde ein Cr-N-Zr-Y-Übergang gewählt und dann bei der Stickstofftotaldruckregelung auf 3.5 Pa, 600 sccm Sauerstoff dazugegeben. Die Morphologie der Schicht ist sehr porös und weist deshalb viel Schichtoberfläche auf. Die tetragonale Phase dominiert im XRD Spektrum, wobei kubische Anteile nicht ausgeschlossen werden können.

Das erfindungsgemässe Verfahren unterscheidet sich besonders deutlich von anderen Methoden der Herstellung von ZrO2 (kubisch und/oder tetragonal) durch das einfache Ausgangsmaterial und durch die Möglichkeit, über dieses Ausgangsmaterial, die Schichteigenschaften, vor allem die Phasenzusammensetzung der Schicht zu beeinflussen bzw. gezielt herzustellen.

Augenscheinlich ist der Unterschied zum Sinterprozess, bei dem die Materialien in Pulverform vorliegen und unter hohe Temperaturen zusammengefügt werden. Die hohen Temperaturen sind notwendig, um das im Sinterprozess gewünschte Material herzustellen und hängen sehr stark von den Zusätzen an Fremdmaterialien, beispielsweise der Stabilisatorenmaterialien und deren Konzentration ab. Einige Materialien können nicht oder nur in kleinen Mengen hergestellt werden, da sehr hohe Sintertemperaturen notwendig sind. Das schränkt sowohl die Materialvielfalt ein und es begrenzt auch die Wirtschaftlichkeit.

Deutlich ist auch der Unterschied des erfindungsgemässen Verfahrens gegenüber der Elektronenstrahlverdampfung, die sowohl mit den Änderungen in der Zusammensetzung der Schmelze bzw. dem zu sublimierenden oxidhaltigen Material im Tiegel konfrontiert ist, wie auch mit der aufwendigen Regelung des Reaktivgases Sauerstoff.

Ähnlich verhält es sich beim Sputterverfahren, das zwar weniger problematisch als die Elektronenstrahlverdampfung ist, was die Verdampfung von Legierungen betrifft, aber eine komplizierte Regelung des Reaktivgases Sauerstoff erfordert, um eine Targetvergiftung zu vermeiden. Verfahren, die Funkenverdampfung mit Sputtern kombinieren und elementare Targets benutzen, lösen dieses Problem ebenfalls unbefriedigend. Sie können nicht im reinen Sauertoffreaktivgas betrieben werden, da dann einerseits das Sputtertarget als auch andererseits das Funkentarget vergiftet und die Anode der Funkenentladung sich mit einer Oxidschicht bedeckt und die Entladung unterbricht. Zwar wird diese Problematik in der Publikation nicht angesprochen, aber es geht aus der Prozessführung hervor, dass man nicht in reiner Sauerstoffatmosphäre arbeitet, sondern nur Sauerstoff dem Argonarbeitsgas zusetzt.

Erfindungsgemäss werden, im Unterschied zu dem in der Literatur beschriebenen kombinierten Verfahren, Mischtargets für die Herstellung der Zr-Y-O2-Schichten benutzt. Diese Targets können in bekannter Technologie, beispielsweise pulvermetallurgisch im HIP Verfahren, hergestellt werden. Mit diesem Verfahren ist es möglich, Materialien sehr unterschiedlicher Schmelzpunkte miteinander zu verdichten, ohne dass es ein Verschmelzen wie beim Sintern braucht. Die Materialien liegen nach dem Verfahren noch als getrennte Materialien im Target vor.

Ein Vorteil des erfindungsgemässen Verfahrens gemäss einer Ausführungsform ist es, dass diese getrennt vorliegenden Materialien während des Betriebs im Sauerstoff- bzw. im Stickstoff-Sauerstoffgemisch unter der Wirkung des auf dem Target sich bewegenden Funkens miteinander legieren. Da die Temperaturen im Funkenfusspunkt einige 1000°C hoch sein können, lassen sich somit sowohl hochschmelzende Materialien wie Zr mit verschiedenen Konzentrationen von Stabilisatoren, beispielsweise mit Y zwischen 1at% und 25at% auf der Targetoberfläche unmittelbar vor dem Übergang in die Dampfphase einschmelzen.

Diesen Prozess im Argongas durchzuführen würde zu einer Vielzahl von Spritzern führen. Im Sauerstoff oder Stickstoff-Sauerstoffgemisch als Reaktivgas kann man aber diese vom Schmelzpunkt her unterschiedlichen Materialien gut miteinander verbinden. Der Legierungsvorgang an der Targetoberfläche verschafft eine grosse Freiheit in der Wahl des Ausgangsmaterials für die Targetherstellung, da Pulver mit mittleren Korngrössen zwischen 1 µm oder kleiner und 100 µm und grösser verwendet werden können. Mithin ergibt sich eine Variante der erfindungsgemässen Verfahren darin, dass kein Arbeitsgas, wie Argon, eingesetzt wird.

Das Pulsen der Funkenquellen nach US 20070000772 A1 beschleunigt diesen Legierungsvorgang oder Konditionierungsvorgang an der Targetoberfläche. Die Korngrössen des Targets finden sich nicht in der abgeschiedenen Schicht wieder, da es erst zur Konditionierung auf der Targetoberfläche kommt und dann erst die Verdampfung stattfindet.

Wie oben diskutiert, lässt sich die Kristallitgrösse über solche einfach zugängliche Prozessparameter wie Sauerstofffluss, Substrattemperatur und durch die Wahl von Zwischenschichten steuern.

Die für das erfindungsgemässe Verfahren zu verwendenden Targets kann man auch durch Plasmaspritzen herstellen, indem man metallorganische Gase als Precursor zur Abscheidung der metallischen Schichtkomponenten auf einer Targetunterlage benutzt. Vorteil dieses Target-Herstellungsverfahrens ist es, dass man über die Konzentration der Precursor nur jeweils eine Legierung abgeschieden wird. Nachteilig dabei ist die höhere Porosität der plasmagespritzten Targets gegenüber denen im HIP Verfahren hergestellten, die aber prinzipiell im erfindungsgemässen Verfahren unter reiner Sauerstoffatmosphäre beherrscht wird.

Zusammenfassen kann man sagen, dass im Gegensatz zum bisherigen Stand der Technologie, legierte Funkentargets unübertroffene Reproduzierbarkeit im Ausgangsmaterial liefern und die Kombination des Betriebs der Targets unter Sauerstoffatmosphäre unter der Randbedingung von quasi freier Wählbarkeit des Stickstoff-Sauerstoff-Reaktivgasgemisches sowohl die Anpassung der Schichtmorphologie erlaubt als auch die Vorgabe der Schichtphasen.

Im Folgenden sollen nochmals die wichtigsten Vorteile der vorliegenden Erfindung aufgelistet werden, geordnet nach Verfahren und Schichten

### Verfahren

Das Verfahren der reaktiven Funkenverdampfung von Mischtargets aus Zr unter Zugabe von anderen Materialien wie beispielsweise Stabilisatoren St, beispielsweise Y, eignet sich für eine einfache und kostengünstige Synthese von kubischen bzw. tetragonalen Zr-St-Oxid.

Das Verfahren erlaubt die Verwendung von Targets mit einem Konzentrationsverhältnis entsprechend der gewünschten Schichtzusammensetzung. Solche Targets können beispielsweise durch heiss-isostatisches Pressen (HIP) oder Plasmaspritzen kostengünstig hergestellt werden. Beim Plasmaspritzen kann bereits die gewünschte metallische Legierung zum Target abgeschieden werden, also beispielsweise im Verhältnis Zr96/Y4 Zr92/Y8, Zr90/Y10, Zr85/Y15.

Das Verfahren erlaubt die Kombination mit der Synthese unterschiedlicher Schichtmaterialien im gleichen Beschichtungssystem und im gleichen Prozessschritt.

Das Verfahren erlaubt gradierte Übergänge zwischen verschiedenen Materialien zum Zwecke der verbesserten Haftung untereinander, der Anpassung der Schichteigenschften und der gezielten Anpassung der Schichteigenschaften wie Morphologie, Kristallitgrösse, Kristallstruktur oder Phasenzusammensetzung.

Die Benutzung einer Funkenanode, die durch Temperaturwechselzyklen (Ein- und Ausschalten) in Verbindung mit den dadurch hervorgerufenen mechanischen Verformungen, die zum Abplatzen der oxidischen Schichten führen, leitend gehalten wird, trägt mit Vorteil zur Stabilisierung der Funkenverdampfung in Sauerstoffatmosphäre bei.

Bei Totaldruckregelung auf den Stickstoff können durch die Einstellung der Sauerstoffflüsse die verschiedenen Phasen des ZrO2 synthetisiert werden. Der Stickstoff scheint in gewissem Sinne eine Stabilisierung der tetragonalen oder kubischen Phase zu ermöglichen.

Die Zugabe von Stabilisatoren in das Target in einer bestimmten Konzentration, führt im Wesentlichen zu einer synthetisierten Schicht mit gleicher Konzentration, d.h. es ist kein Regelaufwand notwendig wie es bei dem Verdampfen der Materialien von getrennten elementaren Targets der Fall ist. Die Konzentration der Stabilisatoren determiniert im Wesentlichen die Phasen der synthetisierten Schicht bzw. deren Phasenzusammensetzung.

Falls klassische Stabilisatoren verwendet werden, lassen sich unter Beibehaltung der Phase bzw. des Phasengemisches die Kristallitgrösse und Morphologie der Schicht über den Sauerstofffluss und die Substrattemperatur steuern, d.h. dass die Phasen über einen weiten Bereich unabhängig vom Sauerstofffluss sind.

Die Kombination in der Verwendung von elementaren Zr-Targets und Legierungstargets, die zusätzlich zum Zr feste Stabilisatoren enthalten, ermöglicht auch gradierte Übergänge zwischen Zr-O-Schichten und Zr-Y-O-Schichten, bei denen der Y-Gehalt der Schicht zwischen 0 und dem Y-Gehalt des Legierungstargets variiert werden kann bzw. natürlich auch in umgekehrter Richtung. Beispiel ist die Synthese einer kubischen ZrO2-Schicht, die Stabilisatoren enthält, und bei der dann ein gradierter Übergang zum Zirkonoxid ohne Stabilisatoren stattfindet, d.h. ab einer gewissen Dicke ohne Stabilisatoren wird die harte kubische Struktur mit der aus der weichen monoklinen Struktur verbunden, die dann beispielsweise als Einlaufschicht dienen kann.

Das Verfahren erlaubt den Einbau von stabilisierenden Materialien über die Gasphase, beispielsweise das ausführlich diskutierte Beispiel des Stickstoffs. Der Einbau von diesen Materialien lässt sich aber auch erweitern, indem zusätzliche Reaktivgase (zu Stickstoff und/oder Sauerstoff) eingelassen werden, die sich dann gleichermassen in die Schicht einbauen. Beispiele dafür sind: Kohlenwasserstoffe, Silane, Wasserstoff, Borane, Cyanoverbindungen. Die Zugabe von solchen weiteren Gasen kann auch zu reinem Sauerstoffreaktivgas erfolgen, falls keine Totaldruckregelung des Stickstoffhintergrunds erfolgt.

Die Möglichkeit, mit diesem Verfahren gradierte Übergänge zwischen verschiedenen Schichtmaterialien herzustellen, ist von besonderer Bedeutung bei der Anpassung der Schichtmaterialien bezüglich der thermischen Ausdehnungskoeffizienten (gradierte Übergänge zwischen Metallen, Metallnitriden, Metallcarbonitride, Metalloxide). Diese Gradierungsmöglichkeit erlaubt es, das bisher ungelöste Problem der guten Schichthaftung auf metallischen Unterlagen zu lösen.

Die Möglichkeit der Gradierung erlaubt weiterhin auch noch das Anpassen der thermischen Leitfähigkeiten der Schichten. Messungen haben für eine kubisch stabilisierte Zr-Y-O-Schicht thermische Leitfähigkeiten von 1.8 bis 2.5 W/(mK) (morphologieabhängig) ergeben. Diese thermische Leitfähigkeit ist kleiner als die von anderen Oxidschichten, beispielsweise vom Al-Cr-O (3.2....), die ebenfalls mit reaktiver Funkenverdampfung hergestellt wurden. Das erlaubt die Anpassung von Wärmeübergängen in Schichtsystemen.

Die erfindungsgemässen Einflussmöglichkeiten auf die Schichtmorphologie und die Phasenzusammensetzung erlaubt auch die Einstellung von mechanischen Eigenschaften wie Schichthärte und -zähigkeit.

Die Verwendung von Legierungstargets führt im Gegensatz zum Stand der Technik im Wesentlichen zu keiner Entmischung der Targetkomponenten in der Schicht, d.h. die Targetzusammensetzung findet sich im Wesentlichen auch in der Schicht wieder, und liefert Kristallitgrössen in der Schicht, die unabhängig von der Kristallitgrösse im Targetmaterial sind.

Das Verfahren reduziert beträchtlich das Spritzen des Targetmaterials wie es bei anderen Verfahren auftritt dadurch, dass es das Pulver im Ausgangsmaterial (Target) weitgehend zu intermetallischen Verbindungen an der Targetoberfläche umwandelt.

Das Verfahren vereinfacht und ermöglicht die Einbringung praktisch aller Stabilisatoren und Dotierungen, die zu einer Erhöhung der Ionenleitfähigkeit beitragen, beispielsweise der Stabilisatoren die in US_05709786 offenbart werden. Dies kann auf einfache Art und praktisch ohne Materialeinschränkung geschehen.

Die Kristallitgrösse der Schicht ist unabhängig von der verwendeten Korngrösse des im Target verwendeten Pulvers einstellbar.

Das Vakuumverfahren in Verbindung mit der Verwendung der aus reinen Pulvern hergestellten Targets reduzieren Verunreinigungen der Schicht durch andere Stoffe auf unter 1at%.

Der Legierungsvorgang auf dem Target verläuft gewöhnlich rasch und beeinträchtig die Zwischenschichtqualität i.a. nicht. Er kann aber auch, falls notwendig, von der Schichtabscheidung auf den Substraten durch die Benutzung von Blenden vor dem Target getrennt werden.

### Vorteile der Zirkoniumoxidschichten (im folgenden Schichten genannt):

Die Schichten können kubische oder teragonale Phasen aufweisen, obwohl sie keine Anteile an "klassischen Stabilisatoren", z.B. Y, in der Schicht haben.

Die kubische bzw. tetragonale Phase der Schicht kann auf einer kubischen Unterlagsschicht aufgewachsen werden. Von besonderem Vorteil ist das Wachstum auf Unterlagsschichten kubischer Phase welche im Wesentlichen Zr als metallischen Bestandteil enthalten, z.B. kubisches ZrN, kubisches ZrO oder kubisches bzw. tetragonales ZrO2.

Die Schichten verschiedener Phase oder Phasenzusammensetzung können einen gradierten Übergang zur Unterlagsschicht aufweisen, der sich in einem N-0-Gradienten widerspiegelt und dessen Tiefenprofil innerhalb der Schicht beispielsweise mittels SIMS nachgewiesen werden kann.

Die Phase der Schicht oder deren Phasenzusammensetzung bleibt im Substrattemperaturbereich zwischen 200°C und 700°C im Wesentlichen erhalten. Es ändert sich lediglich die Kristallitgrösse, d.h. bei tiefer Temperatur wird die Schicht feinkristallin bzw. amorph und erhält grössere Kristallite bei höherer Substrattemperatur. Auf diese Art lassen sich Schichten sowohl mit Kristallgrössen im Nanometerbereich herstellen, aber auch Kristallitgrössen bis 100 nm und darüber.

Die synthetisierten Zr02-Schichten sind unterstöchiometrisch bezüglich des Sauerstoffs, nachweisbar durch eine RBS-Analyse. Es sei hier angemerkt, dass bei dieser RBS-Analyse auch berücksichtigt wird, dass die Elemente Zr und Y im Spektrum ohne weiteres nicht trennbar sind, dass dies aber bei der Abschätzung berücksichtigt wurde, ebenso wie die unterschiedliche Wertigkeit von Zr (ZrO2) und Y(Y2O3) bei der Oxidbildung, so dass selbst bei Berücksichtigung dieser Effekte noch Unterstöchiometrie des Sauerstoffs bzgl. Zr vorliegt.

Die Schichten weisen die für das Funkenverdampfen typischen metallische Spritzer auf, die aus dem vorwiegend aus dem hochschmelzenden Zr bestehen und nicht durchoxidiert sind.

Mit den oben beschriebenen Eigenschaften eignen sich die mit dem erfindungsgemässen Verfahren hergestellten Schichten sehr gut für unterschiedlichste Anwendungen.

Gemäss vorliegender Erfindung werden solche mittels Funkenverdampfen hergestellten Schichten vorzugsweise als Festelektrolyten in Brennstoffzellen verwendet.

Aufgrund der guten ionenleitenden Eigenschaften sind die Schichten sehr gut in Sensoren einsetzbar.

Wie oben diskutiert bilden die erfindungsgemäss hergestellten Schichten sehr gute Thermobarriereschichten und können so zum Schutz von Werkzeugen und Komponenten wie zum Beispiel Turbinenschaufeln und Turbolader eingesetzt werden. Ausserdem sind die erfindungsgemässen Zirkonoxidschichten mit Vorteil als Hochtemperatur-Versschweissschutzschicht für Werkzeuge und insbesondere für Schneidewerkzeuge wie z.B. Wendeschneidplatten und Bohrer einsetzbar.

Im Rahmen der vorliegenden Anmeldung wurde ein Verfahren zur Herstellung von Zirkonoxidschichten vorgestellt mit dem, wenn die Zirkonoxidschichten als Festelektrolytschicht eingesetzt werden, diese Festelektrolytschicht mit anderen Unterlagen und/oder Schichten mittels gradierte Übergänge problemlos verbunden werden können.

Mit dem vorgestellten Verfahren sind gezielte Änderungen der Schichtmorphologie ohne Phasenänderungen in einfacher Weise möglich.

Andererseits kann im Rahmen des erfindungsgemässen Verfahrens durch einfache Änderung des Sauerstoffflusses die Phase der Schicht, beispielsweise von kubisch zu monoklin geändert werden.

Es wurde gezeigt, dass mittels des erfindungsgemässen Verfahrens insbesondere wenn ein klassischer Stabilisator verwendet wird die Kristallitgrösse durch Änderung des Sauerstoffflusses und/oder der Substrattemperatur gezielt geändert werden kann.

Im Rahmen des vorgestellten erfinderischen Verfahrens ist es möglich klassische Stabilisatoren die selbst einen hohen Schmelzpunkt besitzen in die Schicht bei wesentlich geringeren Substrattemperaturen einzubauen.

Es wurde gezeigt, dass im Rahmen des erfinderischen Verfahrens Multilagenstrukturen mit Bilayern im Nanometerbereich erzeugt werden können. Beispiele solcher Bilayer sind ZrN/ZrOx Übergänge, ZrO/ZrO2 Übergänge, ZrO2 (trigonal oder cubisch) /ZrO2 (monoklin) Übergänge.

Es wurde gezeigt, dass die für das Verfahren notwendigen Ausgangsmaterialien einfach herzustellen und einfach in der Handhabung sind.

Ausserdem wurde gezeigt, dass mit dem erfindungsgemässen Verfahren Schichten im Wesentlichen ohne unerwünschte Bestandteile realisiert werden können.

Es wurde ausserdem gezeigt, dass im Rahmen des erfindungsgemässen Verfahrens mit Sauerstoffpartialdrücken gearbeitet werden kann, die grösser als 0.1 Pa sind.

Abschliessend sei noch auf die Möglichkeit hingewiesen, mit Hilfe des Verfahrens nicht nur kubische Zirkonoxidschichten, sondern auch solche Pulver herzustellen. Hierzu kann beispielsweise der Totaldruck in der Funkenverdampfungsanlage so hoch gewählt werden, dass aufgrund der stark reduzierten mittleren freien Weglänge ein Grossteil des Materials nicht auf einem zu beschichtenden Substrat landet, sondern als Pulver in der Kammer bleibt.

Eine andere Möglichkeit wäre es, die Substrate vor der Beschichtung mit einer leicht zu entfernenden Opferschicht zu belegen, so dass diese, zusammen mit der nachgängig aufgebrachten Zirkonoxidschicht entfernt werden kann. Als Opferschicht eignet sich beispielsweise eine dünne Graphitschicht, die einfach aufgesprüht werden kann.

### 9. Tabellen

**Tabelle 1:**

| *Probe* | *Schichtsystem* | *Sauerstofffluss [sccm]* | *Targets* | *Kristallphasen im FL* | *Zusammensetzung des FLZr₁OₓN_{y}* |
|---|---|---|---|---|---|
| | | | | | |
| *777* | *ZrN* | *0* | *SL: 4xZr* | *ZrN (cubic F)* | *x = 0* |
| | | | | | *y = 1.1* |
| *778* | *SL: ZrN* | *50* | *SL: 4xZr* | *ZrN (cubic F) bzw.* | *x = 0.12* |
| | *FL: Zr-O-N* | | *FL: 4xZr* | *ZrO (cubic F)* | *y = 1.12 (N*/*O = 9.3)* |
| *779* | *SL: ZrN* | *200* | *SL: 4xZr* | *ZrN (cubic F) bzw.* | *x = 0.74* |
| | *FL: Zr-O-N* | | *FL: 4xZr* | *ZrO (cubic F)* | *y* = *1.26 (N*/*O = 1.7)* |
| *799* | *SL: ZrN* | *250* | *SL: 4xZr* | *ZrO2*/*Zr-O-* | *x = 1* |
| | *FL: Zr-O-N* | | *FL: 4xZr* | *N (cubic F)* | *y = 0.61 (N*/*O = 0.6)* |
| *793* | *SL: ZrN* | *300* | *SL: 4xZr* | *ZrO2*/*Zr-O-N* | *x = 1.19* |
| | *FL: Zr-O-N* | | *FL: 4xZr* | *(cubic F)* | *y = 0.52* (*N*/*O = 0.4)* |
| *780* | *SL: ZrN* | *400* | *SL: 4xZr* | *ZrO2 (monoklin)* | *x = 2.05* |
| | *FL: Zr-O-N* | | *FL: 4xZr* | *Zr-O-N (cubic)* | *y = 0 (N*/*O = 0)* |

### Legende:

*FL* ... *Funktionsschicht*
*SL* ... *Zwischenschicht, Unterlagsschicht*

**Tabelle 2:**

| *Probe* | *Schichtsystem* | *Sauerstofffluss [sccm]* | *Targets* | *Kristallphasen im FL* | *Zusammensetzung des FL Zr₁Oₓ* |
|---|---|---|---|---|---|
| | | | | | |
| *909* | *SL: ZrN* | *350* | *SL: 4xZr* | *Zr-O (monoklin)* | *x = 1.9* |
| | *FL: Zr-O-(N)* | | | | |
| *911* | *SL: ZrN* | *200* | *SL: 2xZr* | *Zr-Y-O (cubic)* | *x = 1.85* |
| | *FL: Zr-Y-O- (N)* | | *FL: 2xZr (85at%)* /*Y ( 15at%)* | | |
| *912* | *SL: ZrN* | *300* | *SL: 2xZr* | *Zr-Y-O (cubic)* | *x = 1.80* |
| | *FL: Zr-Y-O- (N)* | | *FL : 2xZr (85at%)* /*Y ( 15at%)* | | |
| *910* | *SL: ZrN* | *350* | *SL: 2xZr* | *Zr-Y-O (cubic)* | *x = 1.80* |
| | *FL: Zr-O-(N)* | | *FL: 2xZr (85at%)* /*Y ( 15at%)* | | |

**Tabelle 3:**

| *Probe* | *Schichtsystem* | *Sauerstofffluss [sccm]* | *FWHM (2Θ = 30°)* | *FWHM (2Θ* = *50°)* | *Abschätzung der Kristallit grösse [nm]* |
|---|---|---|---|---|---|
| *909* | *SL: ZrN* | *350* | *0.34* | *0.37* | *60* |
| | *FL: Zr-O-(N)* | | | | |
| *911* | *SL: ZrN* | *200* | *0.42* | *0.60* | *32* |
| | *FL: Zr-Y-O- (N)* | | | | |
| *912* | *SL: ZrN* | *300* | *0.40* | *0.49* | *40* |
| | *FL: Zr-Y-O- (N)* | | | | |
| *910* | *SL: ZrN* | *350* | *0.36* | *0.44* | *50* |
| | *FL: Zr-O-(N)* | | | | |

**Tabelle 4:**

| *Probe* | *Schichtsystem* | *Sauerstofffluss [sccm]* | *Targets* | *Kristall phasen im FL* | *Zusammensetzung des FL Zr₁OₓN_{y}* |
|---|---|---|---|---|---|
| | | | | | |
| *916* | *SL: TiCN* | *200* | *SL: 4xTi* | *ZrO2 (tetrago nal, evntuell auch kubische Phase)* | *x = 1.1* |
| | *FL: Zr-Y-O- (N)* | | *FL: 2xZr(92at%)*/ *Y(8at%)* | | *y = 0.4* |
| | | | | | *(N*/*O = 0.39)* |
| *913* | *SL: TiCN* | *250* | *SL: 4xTi* | *ZrO2 (tetrago nal, evntuell auch kubische Phase)* | *x = 1.80* |
| | *FL: Zr-Y-O- (N)* | | *FL: 2xZr (92at%)* / *Y(8at%)* | | *y = 0.07* |
| | | | | | *(N*/*O = 0.04)* |
| *914* | *SL: TiCN* | *350* | *SL: 4xTi* | *ZrO2 (tetrago nal, evntuell auchkubische Phase)* | *x = 1.95* |
| | *FL: Zr-Y-O- (N)* | | *FL: 2xZr (92at%)* / *Y(8at%)* | | *y = 0* |
| | | | | | *(N*/*O = 0)* |
| *915* | *SL: TiCN* | *400* | *SL: 4xTi* | *ZrO2 (tetrago nal, evntuell auch kubische Phase)* | *x = 1.80* |
| | *FL: Zr-Y-O- (N)* | | *FL: 2xZr (92at%)* / *Y(8at%)* | | *y = 0* |
| | | | | | *(N*/*O = 0)* |
| *917* | *SL: ZrN* | | *250SL: 4xTi* | *ZrO2 (vorwieg end kubische Phase, eventuel l Anteile tetragon aler Phase)* | *x = 1.80* |
| | *FL: Zr-Y-O-(N) mit ausgeprä gtem ZrN-Übergang* | | *FL: 2xZr(92at%)*/ *Y(8at%)* | | *y = 0.1* |
| | | | | | *(N*/*O = 0.06)* |

**Tabelle 5:**

| *Probe* | *Schichtsystem* | *Sauerst offfluss [sccm]* | *FWHM (2Θ = 30°)* | *FWHM (2Θ* = *50°)* | *Abschätzung der Kristallit grösse [nm]* |
|---|---|---|---|---|---|
| | | | | | |
| *916* | *SL: TiCN* | *200* | *2.09* | *2.30* | *5* |
| | *FL: Zr-Y-O- (N)* | | | | |
| *913* | *SL: TiCN* | *250* | *0.90* | *1.09* | *11* |
| | *FL: Zr-Y-O- (N)* | | | | |
| *914* | *SL: TiCN* | *350* | *0.44* | *0.63* | *30* |
| | *FL: Zr-Y-O- (N)* | | | | |
| | *SL: TiCN* | *400* | *0.46* | *0.70* | *25* |
| *915* | *FL: Zr-Y-O- (N)* | | | | |
| *917* | *SL: ZrN* | *250* | *1.03* | *1.21* | *10* |
| | *FL: Zr-Y-O-(N) mit a usgepräg tem ZrN-Übergang* | | | | |

## Patentansprüche

1. Verfahren zur Herstellung einer Zirkonoxid-basierten Schicht auf einem Ablege-Substrat, unter Einsatz reaktiven Funkenverdampfens, mit gepulstem Funkenstrom und/oder mit Anlegen eines zum Funkentarget senkrechten Magnetfeldes, **dadurch gekennzeichnet, dass** ein ein elementares Zirkon und mindestens einen Stabilisator umfassendes Mischtarget eingesetzt wird.

2. Verfahren nach Anspruch 1 **dadurch gekennzeichnet, dass** die Schicht in kubischer und/oder tetragonalen Kristallstruktur hergestellt wird.

3. Verfahren nach Anspruch 1oder 2 **dadurch gekennzeichnet, dass** der Sauerstoffpartialdruck über 0.1Pa gewählt wird, vorzugsweise mindestens zu 10Pa.

4. Verfahren nach einem der Ansprüche 1 bis 3 **dadurch gekennzeichnet, dass** Konzentrationsverhältnis von Zirkonoxid und Stabilisator an der Schicht mindestens im Wesentlichen durch das Konzentrationsverhältnis von elementarem Zirkonium und Stabilisator am Mischtarget vorgegeben wird.

5. Verfahren nach einem der Ansprüche 1 bis 4 **dadurch gekennzeichnet, dass** durch Wahl der Konzentration des Stabilisators im Mischtarget die kubische und/oder tetragonale Kristallstruktur erreicht wird.

6. Verfahren nach einem der Ansprüche 1 bis 5 **dadurch gekennzeichnet, dass** der Sauerstoffpartialdruck, als bezüglich des Erreichens kubischer und/oder tetragonaler Kristallstruktur mindestens im Wesentlichen freier Stellparameter, für die Vorgabe der Schichtmorphologie eingesetzt wird.

7. Verfahren nach einem der Ansprüche 1 bis 5, **dadurch gekennzeichnet, dass** das Reaktivgas nebst Sauerstoff, Stickstoff umfasst.

8. Verfahren nach einem der Ansprüche 1 bis 7 für die Herstellung der Schicht als Schicht in einem Schichtpaket.

9. Verfahren nach einem der Ansprüche 1 bis 8 **dadurch gekennzeichnet, dass** die Schicht durch Variation des Sauerstoff/Stickstoff -Gehaltes, als Mehrfachlagenschicht hergestellt wird.

10. Verfahren nach einem der Ansprüche 1 bis 9 **dadurch gekennzeichnet, dass** das Ablegen der Schicht bei einer Substrattemperatur zwischen 200°C und 700°C erfolgt.

11. Verfahren nach einem der Ansprüche 1 bis 10 **dadurch gekennzeichnet, dass** die Formierung der kubischen oder tetragonalen Phase entfernt vom thermischen Gleichgewichtszustand vorgenommen wird.

12. Verfahren nach einem der Ansprüche 1 bis 11 **dadurch gekennzeichnet, dass** Oxyde anderer Metalle als von Zirkonium in das Schichtmaterial eingebaut werden.

13. Verfahren nach einem der Ansprüche 1 bis 12, wobei dasAblegesubstrat eine metallische Oberfläche hat, **dadurch gekennzeichnet, dass** eine Stützschicht auf der metallischen Oberfläche abgelegt wird, dann die Schicht auf die Stützschicht, wobei die Stützschicht vorzugsweise aus einem Metall ausser Zr, einem Nitrid oder einem Oxid besteht, vorzugsweise aus ZrN.

14. Verfahren nach einem der Ansprüche 1 bis 13 **dadurch gekennzeichnet, dass** kein Arbeitsgas, wie Argon, eingesetzt wird.

15. Verwendung des Verfahrens nach einem der Ansprüche 1 bis 14 für mindestens eines folgender Zwecke:
- die Herstellung der Schicht als Wachstumsunterlage für ein YSZ;
- zur Erhöhung des Ionentransportes entlang der Korngrenzen wobei die Kristallitgrösse der Schicht vorzugsweise im Nanometerbereich eingestellt wird;
- die Herstellung einer Festelektolytschicht in einer Brennstoffzelle, bei der vorzugsweise mindestens eines folgender Merkmale gilt:
- der Stabilsator wird frei gewählt;
- es werden Schichtzusammensetzung, Phasenzusammensetzung und Schichtmorphologie mindestens weitgehend unabhängig voneinander mittels Regelung von Parametern des Verdampfungsprozesses eingestellt;
- es lässt sich die Schichtmorphologie von glasähnlich bis kolumnar einstellen;
- es wird die Festelekrolytschicht ohne Stabilisator hergestellt;
- die Schicht wird mit einem Gradienten der Schichtmaterialzusammensetzung in Richtung ihrer Dickenausdehnung hergestellt, vorzugsweise ist der Gradient von Zr zu ZrN, zu ZrO zu ZrO2, mit freier Wählbarkeit von Morphologie und Phase;

## Claims

1. A method for producing a zirconium-oxide-based layer on a deposition substrate, using reactive cathodic arc deposition, with pulsed arc current and/or with application of a magnetic field perpendicular to the arc target, **characterized in that** a mixed target comprising elementary zirconium and at least one stabilizer is used.

2. The method according to Claim 1, **characterized in that** the layer is produced in cubic and/or tetragonal crystal structure.

3. The method according to Claim 1 or 2, **characterized in that** the oxygen partial pressure is selected to be greater than 0.1 Pa, preferably at least 10 Pa.

4. The method according to any one of Claims 1 to 3, **characterized in that** the concentration ratio of zirconium oxide and stabilizer at the layer is at least substantially predefined by the concentration ratio of elementary zirconium and stabilizer at the mixed target.

5. The method according to any one of Claims 1 to 4, **characterized in that** by selecting the concentration of the stabilizer in the mixed target, the cubic and/or tetragonal crystal structure is achieved.

6. The method according to any one of Claims 1 to 5, **characterized in that** the oxygen partial pressure, as an at least substantially free control parameter with respect to achieving cubic and/or tetragonal crystal structure, is used for the specification of the layer morphology.

7. The method according to any one of Claims 1 to 5, **characterized in that** the reactive gas comprises nitrogen in addition to oxygen.

8. The method according to any one of Claims 1 to 7 for producing the layer as a layer in a layer packet.

9. The method according to any one of Claims 1 to 8, **characterized in that** the layer is produced by variation of the oxygen/nitrogen content as a multiple ply layer.

10. The method according to any one of Claims 1 to 9, **characterized in that** the deposition of the layer is performed at a substrate temperature between 200°C and 700°C.

11. The method according to any one of Claims 1 to 10, **characterized in that** the forming of the cubic or tetragonal phase is performed remotely from the thermal equilibrium state.

12. The method according to any one of Claims 1 to 11, **characterized in that** oxides of metals other than zirconium are incorporated into the layer material.

13. The method according to any one of Claims 1 to 12, wherein the deposition substrate has a metallic surface, **characterized in that** a support layer is deposited on the metallic surface, then the layer on the support layer, wherein the support layer preferably consists of a metal other than zirconium, a nitride, or an oxide, preferably of ZrN.

14. The method according to any one of Claims 1 to 13, **characterized in that** a working gas, such as argon, is not used.

15. A use of the method according to any one of Claims 1 to 14 for at least one of the following purposes:
- the production of the layer as a growth underlay for a YSZ;
- to increase the ion transport along the grain boundaries, wherein the crystallite size of the layer is preferably set in the nanometer range;
- the production of a solid electrolyte layer in a fuel cell, in which preferably at least one of the following features applies:
- the stabilizer is freely selected;
- layer composition, phase composition, and layer morphology are set at least substantially independently of one another by means of controlling parameters of the vapor deposition process;
- the layer morphology may be set from glassy like to columnar;
- the solid electrolyte layer is produced without stabilizer;
- the layer is produced with a gradient of the layer material composition in the direction of its thickness dimension, preferably the gradient is from zirconium to ZrN, to ZrO to ZrO2, with free ability to select morphology and phase.

## Revendications

1. Procédé de fabrication d'une couche à base d'oxyde de zirconium sur un substrat de dépôt faisant intervenir l'évaporation réactive par arc en courant de l'arc pulsé et/ou l'application d'un champ magnétique perpendiculaire à la cible de l'arc, **caractérisé en ce qu'**on utilise une cible mixte comprenant un zirconium élémentaire et au moins un stabilisateur.

2. Procédé selon la revendication 1, **caractérisé en ce que** la couche est fabriquée suivant une structure cristalline cubique et/ou tétragonale.

3. Procédé selon la revendication 1 ou 2, **caractérisé en ce que** la pression partielle d'oxygène est choisie supérieure à 0,1 Pa, de préférence d'au moins 10 Pa.

4. Procédé selon l'une des revendications 1 à 3, **caractérisé en ce que** le rapport de concentration entre l'oxyde de zirconium et le stabilisateur au niveau de la couche est prédéterminé au moins essentiellement par le rapport de concentration entre le zirconium élémentaire et le stabilisateur au niveau de la cible mixte.

5. Procédé selon l'une des revendications 1 à 4, **caractérisé en ce que**, selon le choix de la concentration du stabilisateur dans la cible mixte, on obtient une structure cristalline cubique et/ou tétragonale.

6. Procédé selon l'une des revendications 1 à 5, **caractérisé en ce que** la pression partielle d'oxygène, en matière d'obtention d'une structure cristalline cubique et/ou tétragonale, est utilisée au moins essentiellement comme paramètre de réglage libre pour la prédétermination de la morphologie de la couche.

7. Procédé selon l'une des revendications 1 à 5, **caractérisé en ce que** le gaz réactif comprend, en plus de l'oxygène, de l'azote.

8. Procédé selon l'une des revendications 1 à 7 pour la fabrication de la couche comme couche dans un paquet de couches.

9. Procédé selon l'une des revendications 1 à 8, **caractérisé en ce que** la couche est fabriquée en couches multiples en faisant varier la teneur en oxygène/azote.

10. Procédé selon l'une des revendications 1 à 9, **caractérisé en ce que** le dépôt de la couche s'effectue à une température de substrat comprise entre 200 °C et 700 °C.

11. Procédé selon l'une des revendications 1 à 10, **caractérisé en ce que** la formation de la phase cubique ou tétragonale est réalisée éloignée de l'état d'équilibre thermique.

12. Procédé selon l'une des revendications 1 à 11, **caractérisé en ce qu'**il est intégré dans la matière de couche des oxydes d'autres métaux que le zirconium.

13. Procédé selon l'une des revendications 1 à 12, dans lequel le substrat de dépôt a une surface métallique, **caractérisé en ce qu'**on dépose sur la surface métallique une couche de support, puis on dépose la couche sur la couche de support, la couche de support étant composée de préférence d'un métal autre que le Zr, d'un nitrure ou d'un oxyde, de préférence en ZrN.

14. Procédé selon l'une des revendications 1 à 13, **caractérisé en ce qu'**il n'est utilisé aucun gaz de travail, comme l'argon.

15. Utilisation du procédé selon l'une des revendications 1 à 14 pour au moins l'une des finalités suivantes :
- la fabrication de la couche comme substrat de croissance pour un YSZ ;
- l'augmentation du transport ionique le long des limites de grain, la taille des cristallites de la couche étant réglée de préférence dans l'échelle nanométrique,
- la fabrication d'une couche d'électrolyte solide dans une pile à combustible, pour laquelle on applique de préférence au moins une des caractéristiques suivantes :
- le stabilisateur est choisi librement ;
- la composition de couche, la composition de phases et la morphologie de couche sont réglées au moins largement indépendamment les unes des autres en réglant les paramètres du processus d'évaporation ;
- la morphologie de couche peut être réglée de type verre à colonnaire ;
- la couche d'électrolyte solide est fabriquée sans stabilisateur ;
- la couche est fabriquée avec un gradient de la matière de couche dans le sens de son épaisseur, le gradient allant de préférence de Zr à ZrN, à ZrO à ZrO2, avec une possibilité de choisir librement la morphologie et la phase.
